(19) Europäisches Patentamt
European Patent Office
Office européen des brevets

(11) **EP 1 716 604 B1**

(12) **EUROPÄISCHE PATENTSCHRIFT**

(45) Veröffentlichungstag und Bekanntmachung des Hinweises auf die Patenterteilung:
**26.07.2017   Patentblatt 2017/30**

(51) Int Cl.:
*H01L 51/40* (2006.01)    *H05B 33/10* (2006.01)
*C09D 11/00* (2014.01)    *H05B 33/14* (2006.01)
*C09K 11/02* (2006.01)    *H01L 51/00* (2006.01)

(21) Anmeldenummer: **05707447.8**

(22) Anmeldetag: **17.02.2005**

(86) Internationale Anmeldenummer:
**PCT/EP2005/001596**

(87) Internationale Veröffentlichungsnummer:
**WO 2005/083814 (09.09.2005 Gazette 2005/36)**

(54) **LÖSUNGEN ORGANISCHER HALBLEITER**

SOLUTIONS OF ORGANIC SEMICONDUCTORS

SOLUTIONS DE SEMI-CONDUCTEURS ORGANIQUES

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **18.02.2004   DE 102004007777**

(43) Veröffentlichungstag der Anmeldung:
**02.11.2006   Patentblatt 2006/44**

(73) Patentinhaber: **Merck Patent GmbH**
**64293 Darmstadt (DE)**

(72) Erfinder:
• **SPREITZER, Hubert**
**68519 Viernheim (DE)**
• **SAUER, Andreas**
**61479 Glashütten (DE)**
• **SCHWAN, Carsten**
**65618 Selters-Eisenbach (DE)**
• **TALLANT, Neil**
**Whitefield,**
**Manchester M45 6TE (GB)**

(56) Entgegenhaltungen:
EP-A- 0 610 929    WO-A-02/069119
WO-A-02/072714    US-A- 5 091 004
US-A1- 2003 127 977

• **PATENT ABSTRACTS OF JAPAN Bd. 016, Nr. 490 (C-0994), 12. Oktober 1992 (1992-10-12) & JP 04 180977 A (HITACHI CHEM CO LTD), 29. Juni 1992 (1992-06-29)**
• **HEBNER T R ET AL: "Ink-jet printing of doped polymers for organic light emitting devices" APPLIED PHYSICS LETTERS, AMERICAN INSTITUTE OF PHYSICS. NEW YORK, US, Bd. 72, Nr. 5, 2. Februar 1998 (1998-02-02), Seiten 519-521, XP012020626 ISSN: 0003-6951**

**Beschreibung**

Die vorliegende Erfindung betrifft Lösungen organischer Halbleiter, sowie deren Verwendung in der Elektronikindustrie

In einer Reihe verschiedenartiger Anwendungen, die im weitesten Sinne der Elektronikindustrie zugerechnet werden können, ist der Einsatz organischer Halbleiter als funktionelle Materialien seit geraumer Zeit Realität bzw. wird in naher Zukunft erwartet. So finden bereits seit etlichen Jahren organische Ladungstransportmaterialien (i. d. R. Lochtransporter auf Triarylaminbasis) Verwendung in Kopiergeräten. Die Entwicklung organischer Transistoren (O-TFTs, O-FETs), organischer integrierter Schaltungen (O-ICs) und organischer Solarzellen (O-SCs) ist im Forschungsstadium schon sehr weit gediehen, so dass eine Markteinführung innerhalb der nächsten Jahre erwartet werden kann. Bei den organischen Elektrolumineszenzvorrichtungen (OLEDs) ist die Markteinführung bereits erfolgt, wie beispielsweise die Autoradios der Firma Pioneer oder eine Digitalkamera der Firma Kodak mit "organischem Display" belegen. Auch bei den polymeren lichtemittierenden Dioden (PLEDs) ist ein erstes Produkt in Form einer kleinen Anzeige in einem Rasierapparat der Firma Philips N. V. am Markt erhältlich. Der allgemeine Aufbau solcher PLEDs ist in WO 90/13148 wiedergegeben. Trotz aller Fortschritte sind noch deutliche Verbesserungen nötig, um diese Displays zu einer echten Konkurrenz zu den derzeit marktbeherrschenden Flüssigkristallanzeigen (LCD) zu machen bzw. diese zu überflügeln.

Um zu vollfarbigen Anzeigevorrichtungen zu kommen, ist es nötig, Beschichtungsverfahren zu entwickeln, die es erlauben, die drei Grundfarben (rot, grün, blau) räumlich getrennt aufzubringen. Da die Polymere im Allgemeinen aus Lösung aufgebracht werden, sind hierbei Druckverfahren die Möglichkeit der Wahl. Derzeit wird wegen der guten Steuerbarkeit, der erreichbaren Auflösung und der großen Variabilität hauptsächlich an Tintenstrahl-Druckverfahren (ink-jet printing, IJP) gearbeitet. Grundsätzlich eignen sich aber auch andere Druckverfahren, wie z. B. Offsetdruck, Transferdruck oder Tiefdruckverfahren.

Das Tintenstrahl-Druckverfahren zur Herstellung von PLEDs und entsprechenden Displays ist bereits mehrfach beschrieben:

In EP 0880303 ist die Verwendung von IJP zur Herstellung von PLEDs erstmals beschrieben. Gemäß dieser Schrift wird eine Lösung eines organischen Lumineszenzmaterials durch IJP auf ein photolithographisch vorbereitetes Substrat mit Partitionierungen und Anode aufgebracht. Durch die Verwendung verschiedener Lösungen können so verschiedenfarbige Pixel (Bildpunkte) erzeugt werden. In dieser Anmeldung wird mehr das Prinzip beschrieben, weniger aber eine technische Lehre erteilt, welche die praktische Durchführung und die dabei zu lösenden Probleme aufzeigt. So gibt es bis auf drei eher aufgabenhafte Formulierungen keine Lehre über die Konsistenz und die Darstellung der entsprechenden Lösungen. Es wird nur formuliert, die Lösungen müssten einen Kontaktwinkel zwischen 30 und 170° gegenüber dem Material der Düsenplatte (nozzle plate) des IJ-Druckkopfes haben. Des Weiteren soll die Viskosität der Lösung zwischen 1 und 20 mPa·s (cps) und die Oberflächenspannung zwischen 20 und 70 dyn/cm liegen. Diese Angaben stellen technisch keine relevante Hilfestellung oder Lehre dar, da der breite Kontaktwinkel praktisch für fast alle Lösungen oder Lösemittel vorliegt, wenn nur die Düsenplatte entsprechend präpariert wird. Ebenso beginnt der angegebene Viskositätsbereich bereits bei nahezu purem Lösemittel (zum Vergleich: reines Toluol hat ca. 0.6 mPa·s, Tetralin hingegen bereits ca. 2 mPa·s) und geht, je nach Molekulargewicht der eingesetzten organischen Verbindung, bis hin zu sehr hohen Konzentrationen. Schließlich gibt auch der angegebene Oberflächenspannungsbereich keine echte Einschränkung: Die meisten verwendbaren organischen Lösemittel haben Werte im angegebenen Bereich; durch Auflösen von Polymeren verändern sich diese Werte nicht wesentlich.

Die Herstellung organischer Filme oder Pixel durch IJP zeigt allerdings eine Reihe von Problemen, die noch nicht zufriedenstellend gelöst sind und die auch in der oben genannten Anmeldung unberücksichtigt bleiben:

Problem 1: Lösemittel mit zu hohem Dampfdruck, d. h. mit einem zu niedrigen Siedepunkt, führen dazu, dass die IJ-Lösungen im Druckkopf, an der Düse bzw. an der Düsenplatte eintrocknen. Dies hat zur Folge, dass die Düse verstopfen kann und der Druckprozess schlecht reproduzierbar wird. Ein solches System ist für eine industrielle Fertigung ungeeignet.

Problem 2: Enthält die IJ-Lösung verschiedene Materialien (Blends), kann es beim Eintrocknen der Lösung dazu kommen, dass zunächst eine dieser Substanzen ausfällt. Dies führt zu einer inhomogenen Verteilung der verschiedenen Materialien im gebildeten Pixel. Derartig inhomogene Pixel zeigen in der OLED eine deutliche Verschlechterung der Device-Eigenschaften.

Problem 3: Beim Eintrocknen der einzelnen Tropfen der IJ-Lösungen auf dem Substrat kann es dazu kommen, dass die Schichtdicke des gebildeten Pixels stark variiert. In der Regel sind die Ränder des Pixels deutlich höher als die Mitte des Pixels. Dies führt nun in der PLED zu einer inhomogenen Leuchtintensität innerhalb des Pixels und auch zu unterschiedlicher Degradation der verschiedenen Bereiche des Pixels.

Problem 4: Trocknet die Lösung in aufgedruckten Pixeln zu langsam ein bzw. ändert sich während des Trocknungsvorgangs die Viskosität nur relativ wenig, kann es beim Bewegen des Substrats (bei technischen IJPs wird das Substrat in der Regel in einer Richtung gefördert, der Druckkopf bewegt sich vertikal dazu) dazu kommen, dass Lösung über die Pixelbegrenzung (i. d. R. werden die Pixel durch photolithographisch erzeugte Wände begrenzt) fließt. Eine Mischung der Tinten ist insbesondere dann schädlich, wenn sich dadurch verschiedenfarbige Lösungen mischen. Grundsätzlich führen die nicht erwünschten Schichtdickenvariationen und daraus resultierenden Inhomogenitäten zu nicht reproduzierbarem Emissionsverhalten.

Problem 5: Es ist notwendig, das Lösemittel möglichst vollständig aus dem abgeschiedenen Film zu entfernen, um optimale Device-Eigenschaften zu erhalten. Hat das Lösemittel einen zu niedrigen Dampfdruck (also einen zu hohen Siedepunkt), so ist dies, falls überhaupt, nur unter erheblichem technischen Aufwand möglich.

Problem 6: Trocknet die Lösung in aufgedruckten Pixeln zu schnell ein, so besteht die Gefahr, dass der organische Halbleiter aus der Lösung ausfällt. Dies führt im Allgemeinen zu Inhomogenitäten des gebildeten Films und damit zu Inhomogenitäten in der Elektrolumineszenz.

Zur Lösung des vorstehenden Problems 1 wird in WO 00/59267 vorgeschlagen, als Lösemittel substituierte Benzolderivate mit mindestens 3 C-Atomen im Substituenten bzw. in den Substituenten zu verwenden. Dabei werden Lösemittel, deren Siedepunkt bei mindestens 200 °C liegt, bevorzugt. Das als besonders bevorzugt gelehrte Lösemittel Dodecylbenzol hat jedoch einen Siedepunkt von ca. 300 °C. Weiterhin wird eine Mischung aus mindestens zwei Lösemitteln vorgeschlagen, wobei das erste die oben genannten Eigenschaften aufweist und das zweite auch einen niedrigeren Siedepunkt aufweisen kann, dieser aber wiederum mindestens 140 °C beträgt. Dieser Aspekt ist allerdings unklar, da hier auch Lösemittel genannt werden, die einen deutlich niedrigeren Siedepunkt aufweisen, wie z. B. Toluol (Sdp. 111 °C), Chloroform (Sdp. 61 °C) und Tetrachlorkohlenstoff (Sdp. 76 °C).

Diese Lösungen sollen folgende Problemlösungen bringen: Zunächst verhindert das hochsiedende Lösemittel die Eintrocknung der Lösung im Druckkopf (Lösung des Problems 1). Zur Homogenisierung des Pixels (Lösung des Problems 2) und vor allem, um das schwer zu entfernende hochsiedende Lösemittel zu entfernen, wird eine Nachbehandlung vorgeschlagen. Dabei wird der Pixel auf Temperaturen zwischen 40 und 200 °C erhitzt. Dies geschieht zunächst unter einem Überdruck von 2 bis 100 bar, um wieder eine homogene Lösung zu erzeugen. Anschließend wird unter Unterdruck weiter getempert, bis alles Lösemittel entfernt ist.

Der Lösungsvorschlag gemäß WO 00/59267 weist gravierende technische Probleme auf: Das vollständige Entfernen des Lösemittels ist essentiell für gute Device-Eigenschaften, ist aber gerade bei den bevorzugten hochsiedenden Lösemitteln (z. B. Dodecylbenzol, Sdp. ≈ 300 °C) in einem technischen Prozess sehr aufwändig und kaum realisierbar. Die geschilderten Maßnahmen zur Homogenisierung (Hochdruck, Tempern, Vakuum) sind für eine technische Massenfertigung - wegen anlagentechnischer und finanzieller Probleme - kaum geeignet. Einige der genannten zugemischten Lösemittel (z. B. Chloroform, Tetrachlorkohlenstoff) sind giftig bzw. stehen sogar unter dem Verdacht, cancerogene Eigenschaften zu besitzen, und sollten deshalb vermieden werden.

In EP 1103590 werden Lösungen zur Herstellung einer organischen Schicht in Elektrolumineszenzvorrichtungen durch Druckverfahren beschrieben, wobei mindestens ein Lösemittel bei Temperatur der Auftragung einen Dampfdruck von kleiner 500 Pa hat. Dadurch lassen sich die Schichten besser drucken, als dies mit Lösemitteln mit höherem Dampfdruck der Fall ist. Im Text werden hier als Druckverfahren nur Verfahren beschrieben, bei denen die Beschichtungsflüssigkeit auf ein Transfersubstrat und von dort auf das Substrat übertragen wird. Dies schließt Tintenstrahl-Druckverfahren aus. Aus der Anmeldung geht auch nicht hervor, ob oder in welcher bevorzugten Ausführungsform sich eine solche Lösung für IJP anwenden lassen könnte, um die oben beschriebenen Probleme zu beheben.

In WO 01/16251 werden Formulierungen zur Herstellung von Polymerschichten in Elektrolumineszenzvorrichtungen beschrieben, wobei das Lösemittel mindestens entweder ein Terpen oder eine polyalkylierte aromatische Verbindung enthält. Als Vorteil wird beschrieben, dass die Lösungen als solche hohe Stabilitäten bei praktisch unverändertem Photolumineszenzverhalten zeigen. Eigenschaften dieser Formulierungen beim Druckvorgang bzw. bei der Filmbildung selbst werden nicht beschrieben, so dass man davon ausgehen muss, dass die oben beschriebenen Probleme durch diese Erfindung nicht gelöst werden.

In WO 02/069119 wird beschrieben, wie die inhomogene Verteilung des Materials innerhalb des getrockneten Tropfens verbessert werden kann (Lösung des Problems 3). Dafür wird eine Mischung aus zwei Lösemitteln verwendet, wobei das erste einen relativ hohen Siedepunkt hat und das Material relativ schlecht löst und das zweite einen relativ niedrigen Siedepunkt hat und das Material relativ gut löst. Durch das schnelle Verdampfen des flüchtigeren Lösemittels entsteht beim Trocknen eine gesättigte Lösung des Materials, das in Folge schnell ausfällt. Dadurch wird ein radialer Fluss des Materials zu den Rändern des Pixels verhindert und eine relativ gleichmäßige Materialverteilung ermöglicht. Diese Methode zeigt jedoch den entscheidenden Nachteil, dass das Material nicht gleichmäßig eintrocknet, sondern dass sich ein Niederschlag bildet, der zu deutlichen Inhomogenitäten des Films führt. In US 2003/0127977 wird beispielsweise durch SEM (scanning electron microscopy) gezeigt, dass der Film schlechte Eigenschaften zeigt, wenn das Material beim Trocknen ausfällt. Dadurch ist keine gleichmäßige und homogene Elektrolumineszenz aus dem Pixel möglich. Durch die Unregelmäßigkeit des Films ist weiterhin kein gleichmäßiger Stromfluss möglich. Es ist zu vermuten, dass sich dadurch bevorzugte Stromkanäle ausbilden, die dann letzten Endes zu Kurzschlüssen und somit deutlich geringerer Stabilität des Devices führen.

In WO 02/072714 werden Lösungen in einem Gemisch aus zwei (oder auch drei) Lösemitteln vorgeschlagen, wobei beide Lösemittel einen Siedepunkt kleiner 200 °C haben und ein Lösemittel einen Siedepunkt zwischen 140 °C und 200 °C hat, die weiterhin keine benzylischen $CH_2$- und CH-Gruppen enthalten und die bestimmte Einschränkungen für die Substituenten an aromatischen Lösemitteln aufweisen. So können Lösemittelreste leichter aus dem Polymerfilm entfernt werden, als dies mit hochsiedenden Lösemitteln möglich ist. Als besonders günstig wird beschrieben, wenn die Lösung schnell eindickt. Dies wird dadurch erreicht, dass binäre oder ternäre Lösemittelgemische verwendet werden, bei denen der organische Halbleiter in dem Lösemittel mit dem höchsten Siedepunkt die geringste Löslichkeit hat bzw. in diesem Lösemittel sehr dick oder gelartig ist. Dann findet beim Eindicken eine schnelle Viskositätssteigerung statt, ohne dass das Material ausfällt. Dadurch wurden bereits sehr gute Fortschritte erzielt; jedoch sind für die Bildung vollständig homogener Schichten und zur vollständigen Behebung des Problems 3 bzw. 6 noch weitere Verbesserungen nötig, und es wäre wünschenswert, Lösungen zur Verfügung zu haben, die beim Eintrocknen noch schneller eindicken.

In US 2003/0127977 werden Lösungen in einem Lösemittel beschrieben, das eine Oberflächenspannung kleiner als 30 dyn/cm und einen Siedepunkt größer als 200 °C hat. Weiterhin werden ternäre Lösemittelsysteme beschrieben, wobei das Polymer in einem Lösemittel eine Löslichkeit von größer 1 % hat, wovon das zweite Lösemittel eine Verdampfungsrate von kleiner 0.1 hat und das dritte Lösemittel eine Oberflächenspannung kleiner als 30 dyn/cm hat. Dadurch erhält man gleichmäßige Polymeroberflächen, die im SEM-Bild (scanning electron microscopy) keine Inhomogenitäten mehr zeigen. Im Vergleich dazu werden inhomogene Oberflächen, die zu Problemen in der Elektrolumineszenz führen, erhalten, wenn das Polymer beim Trocknungsvorgang aus der Lösung ausfällt. In dieser Anmeldung ist allerdings nicht beschrieben, wie die anderen oben beschriebenen Probleme, insbesondere die unterschiedliche Materialverteilung zwischen Pixelmitte und Rand (Problem 3), durch diese Erfindung behoben werden können.

Aus diesen Beschreibungen wird deutlich, dass die oben beschriebenen Probleme 1 bis 6 bisher nicht zufriedenstellend gelöst sind. Es ist daher Aufgabe der vorliegenden Erfindung, hierfür eine technische Verbesserung anzubieten.

Gegenstand der Erfindung sind einphasige, flüssige Zusammensetzungen (Lösungen), enthaltend

- mindestens einen organischen Halbleiter, der mindestens eine hochmolekulare Komponente enthält,
- und mindestens ein organisches Lösemittel A,
- und mindestens ein organisches Lösemittel B,
- und mindestens ein organisches Lösemittel C,

dadurch gekennzeichnet,

- dass der organische Halbleiter in dem reinen Lösemittel A bzw. in dem reinen Lösemittel B in einer Konzentration von mindestens 5 g/L bei Raumtemperatur löslich ist,
- dass die Löslichkeit des organischen Halbleiters in dem reinen Lösemittel C bei Raumtemperatur kleiner als 0.3 g/L ist,
- dass der Siedepunkt aller drei Lösungsmittel A, B und C kleiner als 270°C ist, und
- dass für die Siedepunkte (Sdp.) der Lösemittel A, B, und C gilt, dass Sdp.(A) < Sdp.(C) < Sdp.(B) ist und/oder für die jeweiligen Dampfdrücke (p) bei der Temperatur des Beschichtungsverfahrens der Lösemittel A, B und C gilt, dass p (A) > p (C) > p (B).

Die Temperatur des Beschichtungsverfahrens wird bei technischen Prozessen i. d. R. im Bereich von 10 bis 80, bevorzugt 15 bis 50, insbesondere 20 bis 40°C liegen.

Lösungen im Sinne dieses Anmeldungstextes sind flüssige, homogene Mischungen von Festsubstanzen in flüssigen Lösemitteln, in denen die Feststoffe molekulardispers gelöst vorliegen, d. h. die Mehrzahl der Feststoffmoleküle liegt tatsächlich gelöst und nicht in Form von Aggregaten bzw. Nano- oder Mikropartikeln vor.

Unter einem organischen Lösemittel im Sinne dieser Erfindung sollen organische Stoffe verstanden werden, die andere Stoffe auf physikalischem Wege zur Lösung bringen können, ohne dass sich beim Lösungsvorgang der lösende oder der gelöste Stoff chemisch verändern.

Unter einem guten Lösemittel im Sinne dieser Erfindung soll ein organisches Lösemittel verstanden werden, in dem der organische Halbleiter bei einer Konzentration von mindestens 5 g/L bei Raumtemperatur und Normaldruck unter Bildung einer klaren fließfähigen Lösung löslich ist.

Unter einem schlechten Lösemittel im Sinne dieser Erfindung soll ein organisches Lösemittel verstanden werden, in dem der organische Halbleiter bei der oben genannten Konzentration bei Raumtemperatur und Normaldruck keine klare Lösung ergibt, d. h. in dem er ausflockt oder ein Gel bildet. Bevorzugt ist die Löslichkeit des organischen Halbleiters in dem schlechten Lösemittel bei Raumtemperatur und Normaldruck kleiner als 3 g/L, besonders bevorzugt kleiner als 1 g/L, insbesondere kleiner als 0.3 g/L.

Im Rahmen der vorliegenden Erfindung beträgt die Raumtemperatur 20 °C, und Normaldruck bedeutet 1013 mbar.

Ein weiterer Erfindungsgegenstand ist die Verwendung der erfindungsgemäßen Lösungen, um Schichten des organischen Halbleiters auf einem Substrat zu erzeugen.

Eine bevorzugte Ausführungsform ist dabei die Verwendung von Druckverfahren zur Herstellung der organischen Halbleiterschichten. Besonders bevorzugt ist dabei die Verwendung von Tintenstrahl-Druckverfahren (IJP).

Unter Verwendung der erfindungsgemäßen Lösungen lassen sich Schichten organischer Halbleiter herstellen.

Schichten der an sich bekannten organischen Halbleiter sind in der Literatur bereits beschrieben. Die aus den erfindungsgemäßen Lösungen hergestellten Schichten zeigen gegenüber den bislang beschriebenen verbesserte morphologische Eigenschaften (dies ist u. a. in Beispiel 1.4 belegt). Insbesondere wird die Konstanz der Schichtdicke über die Beschichtungsfläche (z. B. das einzelne Pixel), die Homogenität der Schicht und der Oberfläche, auch bei der Verwendung von Blends bzw. Mischungen organischer Halbleiter, und die Freiheit von so genannten pinholes (mikroskopisch kleine Löcher in der Halbleiterschicht, welche zu fatalen Device-Schäden führen können) durch die verbesserten Anwendungseigenschaften der erfindungsgemäßen Lösungen erheblich verbessert.

Organische Halbleiter im Sinne dieser Anmeldung sind niedermolekulare, oligomere, dendritische oder polymere, organische oder metallorganische Verbindungen bzw. Mischungen von Verbindungen gemeint, die als Feststoff bzw. als Schicht halbleitende Eigenschaften aufweisen, d. h. bei denen die Energielücke zwischen Leitungs- und Valenzband zwischen 0.1 und 4 eV liegt.

Als organischer Halbleiter wird hier entweder eine Reinkomponente, die dann nur eine hochmolekulare Komponente enthält, oder eine Mischung von zwei oder mehreren Komponenten, von denen mindestens eine halbleitende Eigenschaften aufweisen muss, verwendet. Bei der Verwendung von Mischungen ist es jedoch nicht notwendig, dass jede der Komponenten halbleitende Eigenschaften aufweist. So können beispielsweise inerte niedermolekulare Verbindungen in Verbindung mit halbleitenden Polymeren verwendet werden. Ebenso können nicht-leitende Polymere, die als inerte Matrix bzw. Binder dienen, zusammen mit einer oder mehreren niedermolekularen Verbindungen, die halbleitende Eigenschaften aufweisen, verwendet werden.

Die hochmolekulare Komponente, die oligomer, polymer oder dendritisch sein kann, hat ein Molekulargewicht $M_w$ von größer 3000 g/mol, bevorzugt von größer 10000 g/mol, besonders bevorzugt von größer 50000 g/mol.

Die potenziell beigemischte nicht-leitende Komponente, ist im Sinne dieser Anmeldung als eine elektro-optisch nicht wirksame, inerte, passive Verbindung zu verstehen.

Bevorzugt sind Lösungen polymerer organischer Halbleiter (welche eventuell weitere Substanzen eingemischt enthalten). Als polymere organische Halbleiter im Sinne der vorliegenden Beschreibung werden insbesondere

(i) die in EP 0443861, WO 94/20589, WO 98/27136, EP 1025183, WO 99/24526, DE 19953806 und EP 0964045 offenbarten, in organischen Lösemitteln löslichen, substituierten Poly-p-arylen-vinylene (PAVs),

(ii) die in EP 0842208, WO 00/22027, WO 00/22026, DE 19981010, WO 00/46321, WO 99/54385 und WO 00/55927 offenbarten, in organischen Lösemitteln löslichen, substituierten Polyfluorene (PFs),

(iii) die in EP 0707020, WO 96/17036, WO 97/20877, WO 97/31048, WO 97/39045 und WO 03/020790 offenbarten, in organischen Lösemitteln löslichen, substituierten Poly-spirobifluorene (PSFs),

(iv) die in WO 92/18552, WO 95/07955, EP 0690086, EP 0699699 und WO 03/099901 offenbarten, in organischen Lösemitteln löslichen, substituierten Poly-paraphenylene (PPPs) oder - biphenylene,

(v) die in DE 10337346.2 offenbarten, in organischen Lösemitteln löslichen, substituierten Poly-dihydrophenanthrene (PDHPs),

(vi) die in WO 04/041901 und EP 03014042.0 offenbarten, in organischen Lösemitteln löslichen, substituierten Poly-trans-indenofluorene und Poly-cisindenofluorene (PIF),

(vii) die in EP 1028136 und WO 95/05937 offenbarten, in organischen Lösemitteln löslichen, substituierten Polythiophene (PTs),

(viii) die in T. Yamamoto et al., J. Am. Chem. Soc. 1994, 116, 4832 offenbarten, in organischen Lösemitteln löslichen Polypyridine (PPys),

(ix) die in V. Gelling et al., Polym. Prepr. 2000, 41, 1770 offenbarten, in organischen Lösemitteln löslichen Polypyrrole,

(x) substituierte, lösliche Copolymere, die Struktureinheiten von zwei oder mehr der Klassen (i) bis (ix) aufweisen, wie zum Beispiel in WO 02/077060 beschrieben,

(xi) die in Proc. of ICSM '98, Part I & II (in: Synth. Met. 1999, 101/102) offenbarten, in organischen Lösemitteln löslichen konjugierten Polymere,

(xii) substituierte und unsubstituierte Poly-vinyl-carbazole (PVKs), wie beispielsweise in R. C. Penwell *et al., J.*

*Polym. Sci., Macromol. Rev.* **1978,** *13*, 63-160 offenbart und

(xiii) substituierte und unsubstuierte Triarylaminpolymere, wie beispielsweise in JP 2000-072722 offenbart,
(xiv) lösliche Polymere, welche phosphoreszierende Einheiten enthalten, wie beispielsweise in EP 1245659, WO 03/001616, WO 03/018653, WO 03/022908, WO 03/080687, EP 1311138, WO 03/102109, WO 04/003105, WO 04/015025 und einigen der weiter oben bereits zitierten Schriften offenbart, verstanden.

Diese polymeren organischen Halbleiter sind via Zitat Bestandteil der vorliegenden Erfindung.

Des weiteren bevorzugt sind auch Lösungen von nicht-leitenden Polymeren (Matrix-Polymere), welche niedermolekulare, oligomere, dendritische oder polymere organische und/oder metallorganische Halbleiter enthalten.

Die erfindungsgemäßen Lösungen enthalten zwischen 0.01 und 20 Gew.%, bevorzugt zwischen 0.1 und 15 Gew.%, besonders bevorzugt zwischen 0.2 und 10 Gew.%, ganz besonders bevorzugt zwischen 0.25 und 5 Gew.% des organischen Halbleiters bzw. des entsprechenden Blends.

Die Viskosität der erfindungsgemäßen Lösungen ist variabel. Allerdings verlangen gewisse Beschichtungstechniken eine Verwendung bestimmter Viskositätsbereiche. So ist für die Beschichtung durch IJP ein Bereich von ca. 4 bis 25 mPa·s als sinnvoll anzugeben. Für andere Druckverfahren, z. B. Tiefdruckverfahren, kann aber auch eine deutlich höhere Viskosität, beispielsweise im Bereich von 20 bis 500 mPa·s, durchaus Vorteile ergeben. Die Einstellung der Viskosität kann durch Wahl des geeigneten Molekulargewichtsbereiches des organischen Halbleiters bzw. Matrix-Polymers sowie durch Wahl des geeigneten Konzentrationsbereiches und Wahl der Lösemittel erfolgen.

Die Oberflächenspannung der erfindungsgemäßen Lösungen ist zunächst nicht eingeschränkt. Durch die Verwendung entsprechender Lösemittelgemische und die Anwendung wird diese aber i. d. R. im Bereich von 20 bis 60 dyn/cm, bevorzugt im Bereich von 25 bis 50, ganz besonders bevorzugt im Bereich von 25 bis 40 dyn/cm liegen.

Die erfindungsgemäßen Lösungen enthalten - wie oben beschrieben - mindestens drei verschiedene organische Lösemittel A, B und C, von denen die Lösemittel A und B gute Lösemittel für den organischen Halbleiter sind, das Lösemittel C ein schlechtes Lösemittel für den organischen Halbleiter ist, und wobei außerdem für die Siedepunkte (Sdp.) der Lösemittel gilt: Sdp.(A) < Sdp.(C) < Sdp.(B) bzw. für die jeweiligen Dampfdrücke (p) bei der Temperatur des Beschichtungsverfahrens der Lösemittel A, B und C gilt: p (A) > p (C) > p (B).

Hierbei ist es bevorzugt, wenn die Siedepunkte aller Lösemittel A, B und C größer als 80 °C sind, bevorzugt größer als 100 °C, besonders bevorzugt größer als 120 °C. Eine mit dieser Bevorzugung schon erreichte weitere technische Einschränkung ist der Verzicht auf einige giftige bzw. nachgewiesen cancerogene Lösemittel, was zum Beispiel auf Chloroform (Sdp. 61 °C), Tetrachlormethan (Sdp. 77 °C) und Benzol (Sdp. 80 °C) zutrifft.

Bevorzugt ist mindestens ein Lösemittel B enthalten, das einen Siedepunkt von mehr als 140 °C aufweist. Diese Grenze ist technisch sinnvoll, da es sich erwiesen - hat, dass bei Verwendung von Lösemitteln mit niedrigerem Siedepunkt das Eintrocknen der Düsen innerhalb weniger Sekunden nach Beendigung des Druckvorganges stattfindet. Sobald dieser Wert mindestens bei etwa 10 Sekunden liegt, kann durch geeignete technische Hilfsmittel (z. B. Druckkopf fährt in Warteposition, Düsen werden mit Kappe mechanisch verschlossen) ein Austrocknen verhindert werden.

Weiterhin bevorzugt sind die Siedepunkte aller Lösemittel A, B und C kleiner oder gleich 250 °C. Bei höher siedenden Lösemitteln ist das restliche Lösemittel nach Filmbildung nur schwierig und unter großem technischen Aufwand vollständig zu entfernen.

Siedepunkt bezieht sich in diesem Anmeldetext auf den Siedepunkt unter Normaldruck (1013 mbar).

Der Schmelzpunkt aller Lösemittel A, B und C ist bevorzugt kleiner oder gleich 15 °C. Ein solcher Schmelzpunkt ist sinnvoll, da die Lösungen unter Umständen (zwischen Herstellung und Einsatz) über Tage bis zu Monaten gelagert bzw. eventuell auch transportiert werden müssen. Hier muss sichergestellt werden, dass die Lösungen auch als solche stabil bleiben und nicht bei Lagerung, Transport und/oder kleineren Temperaturschwankungen ausfrieren oder sonstige nachteiligen Lager- und/oder Transportschäden erleiden.

Weiterhin ist es bevorzugt, wenn die Differenz der Siedepunkte zwischen dem Lösemittel A und dem Lösemittel C mehr als 5 K beträgt, bevorzugt mehr als 10 K, besonders bevorzugt mehr als 20 K. Des Weiteren kann es bevorzugt sein, wenn die Differenz der Siedepunkte zwischen dem Lösemittel C und dem Lösemittel B mehr als 5 K beträgt, bevorzugt mehr als 10 K.

Das Verhältnis der Lösemittel A, B und C zueinander ist in weiten Bereichen variierbar. Um aber die besten Effekte zu erzielen, sollte das Lösemittel A zu einem Anteil von 10 bis 80 Vol.%, bevorzugt 20 bis 70 Vol.%, besonders bevorzugt 25 bis 60 Vol.%, insbesondere 25 bis 50 Vol.% verwendet werden. Weiterhin sollte das Lösemittel B zu einem Anteil von 0.5 bis 40 Vol.%, bevorzugt 1 bis 30 Vol.%, besonders bevorzugt 2 bis 20 Vol.%, insbesondere 3 bis 15 Vol.% verwendet werden. Weiterhin sollte das Lösemittel C zu einem Anteil von 10 bis 90 Vol.%, bevorzugt von 20 bis 80 Vol.%, insbesondere von 30 bis 70 Vol.% verwendet werden. Die Gesamtprozentzahl der Anteile der jeweiligen Lösemittelmischung ergibt dabei immer 100 %.

Es kann auch sinnvoll sein, noch weitere gute und/oder schlechte Lösemittel zusätzlich zu den Lösemitteln A, B und C zu verwenden. So kann es durchaus sinnvoll und bevorzugt sein, jeweils zwei oder mehrere Lösemittel von Typ A und/oder Typ B und/oder Typ C zu verwenden, da dadurch teilweise die Optimierung bezüglich weiterer notwendiger Parameter (z. B. Anpassung der Oberflächenspannung, der Viskosität, etc.) einfacher erreicht werden kann, verglichen zu dem Fall, wo von jedem Typ nur exakt ein Lösemittel verwendet wird.

Des Weiteren kann es auch sinnvoll sein, neben dem organischen Halbleiter bzw. Blend noch weitere Additive, wie z. B. in WO 03/019693 beschrieben, zuzusetzen.

Die Verwendung beispielsweise Aldehyd-haltiger Lösemittel, nitrierter Aromaten und phosphorhaltiger Lösungsmittel (mangelnde Stabilität der Lösungen) und von Styrolderivaten bzw. anderen reaktiven Olefinen (Polymerisationsneigung der Lösemittel) hat sich als wenig vorteilhaft erwiesen.

Als bevorzugte Lösemittel A und B, die sich als gute Lösemittel für eine große Bandbreite organischer Halbleiter erwiesen haben, bieten sich einfach oder mehrfach substituierte aromatische Lösemittel, insbesondere substituierte Benzole, Naphthaline, Biphenyle und Pyridine, an. Bevorzugte Substituenten sind Alkylgruppen, die auch fluoriert sein können, Halogenatome, bevorzugt Chlor und Fluor, Cyanogruppen, Alkoxygruppen, Dialkylaminogruppen, bevorzugt solche mit nicht mehr als 4 C-Atomen, oder auch Estergruppierungen. Besonders bevorzugte Substituenten sind Fluor, Chlor, Cyano, Methoxy, Ethoxy, Methyl, Trifluormethyl, Methylcarboxylat, Ethylcarboxylat und/oder Propylcarboxylat, wobei auch mehrere unterschiedliche Substituenten vorhanden sein können. Aber auch nichtaromatische Lösemittel, wie beispielsweise Ameisensäurederivate, N-Alkyl-Pyrrolidone oder hochsiedende Ether, kommen als gute Lösemittel in Frage.

Besonders bevorzugt als Lösemittel A und/oder B sind die in der nachfolgenden Tabelle 1 aufgeführten Lösemittel mit Siedepunkt zwischen 100 und 300 °C. Darüber hinaus sind für einige der aufgeführten Lösemittel noch die Dampfdrücke im besonders bevorzugten Temperaturbereich von Beschichtungsverfahren mit aufgenommen. Besonders geeignete Lösemittel müssen jedoch für jeden organischen Halbleiter separat bestimmt werden, so dass diese Tabelle nur einen generellen Anhaltspunkt geben kann.

Tabelle 1: Besonders bevorzugte gute Lösemittel A und B

| Lösemittel | CAS-Nummer | Siedepunkt [°C] | Schmelzpunkt [°C] | Dampfdruck bei 20°C [torr] | Dampfdruck bei 40°C [torr] |
|---|---|---|---|---|---|
| 3-Fluor-benzotrifluorid | 401-80-9 | 102 | -81 | | |
| Benzotrifluorid | 98-08-8 | 102 | -29 | | |
| Dioxan | 123-91-1 | 102 | 12 | | |
| Trifluormethoxybenzol | 456-55-3 | 102 | -50 | | |
| 4-Fluor-benzotrifluorid | 402-44-8 | 103 | -41 | | |
| 3-Fluorpyridin | 372-47-4 | 108 | n. a. | | |
| Toluol | 108-88-3 | 111 | -93 | 10,5 | 56,0 |
| 2-Fluortoluol | 95-52-3 | 113 | -62 | | |
| 2-Methylthiophen | 554-14-3 | 113 | -63 | | |
| 2-Fluor-benzotrifluorid | 392-85-8 | 115 | -51 | | |
| 3-Fluortoluol | 352-70-5 | 115 | -87 | | |
| Pyridin | 110-86-1 | 115 | -42 | | |
| 4-Fluortoluol | 352-32-9 | 116 | -56 | | |
| 2,5-Difluortoluol | 452-67-5 | 120 | -35 | | |
| 1-Chlor-2,4-difluorbenzol | 1435-44-5 | 127 | -26 | | |
| 2-Fluorpyridin | 372-48-5 | 127 | n. a. | | |
| 3-Chlorfluorbenzol | 625-98-9 | 127 | n. a. | | |
| 1-Chlor-2,5-difluorbenzol | 2367-91-1 | 128 | -25 | | |
| 4-Chlorfluorbenzol | 352-33-0 | 130 | -27 | | |
| Chlorbenzol | 108-90-7 | 132 | -45 | | |
| 2-Chlorfluorbenzol | 348-51-6 | 138 | -42 | | |
| p-Xylol | 106-42-3 | 138 | 12 | | |

(fortgesetzt)

| Lösemittel | CAS-Nummer | Siedepunkt [°C] | Schmelzpunkt [°C] | Dampfdruck bei 20°C [torr] | Dampfdruck bei 40°C [torr] |
|---|---|---|---|---|---|
| m-Xylol | 108-38-3 | 139 | -47 | | |
| o-Xylol | 95-47-6 | 144 | -24 | 1,8 | 13,3 |
| 2,6-Lutidin | 108-48-5 | 145 | -6 | | |
| 2-Fluor-m-xylol | 443-88-9 | 147 | n. a. | | |
| 3-Fluor-o-xylol | 443-82-3 | 150 | n. a. | | |
| 2-Chlorbenzotrifluorid | 88-16-4 | 152 | -7 | | |
| Dimethylformamid | 68-12-2 | 153 | -61 | | |
| 2-Chlor-6-fluortoluol | 443-83-4 | 154 | -27 | | |
| 2-Fluoranisol | 321-28-8 | 154 | -39 | | |
| Anisol | 100-66-3 | 154 | -37 | 0,82 | 7,0 |
| 2,3-Dimethylpyrazin | 5910-89-4 | 156 | n. a. | | |
| Brombenzol | 106-86-1 | 156 | -31 | | |
| 4-Fluoranisol | 459-60-9 | 157 | -45 | | |
| 3-Fluoranisol | 456-49-5 | 160 | -35 | | |
| 3-Trifluormethylanisol | 454-80-0 | 160 | -65 | | |
| 2-Methylanisol | 578-58-5 | 170 | -34 | | |
| Phenetol | 103-73-1 | 170 | -30 | 0,27 | 3,1 |
| 1,3-Benzodioxol | 274-09-9 | 173 | -18 | | |
| 4-Methylanisol | 104-93-8 | 174 | -32 | 0,30 | 3,0 |
| 3-Methylanisol | 100-84-5 | 175 | -55 | | |
| 4-Fluor-3-methylanisol | 2338-54-7 | 175 | n. a. | | |
| 1,2-Dichlorbenzol | 95-50-1 | 180 | -17 | | |
| 2-Fluorbenzonitril | 394-47-8 | ~180 | n. a. | | |
| 4-Fluorveratrol | 398-62-9 | ~180 | n. a. | | |
| 2,6-Dimethylanisol | 1004-66-6 | 182 | n. a. | | |
| Anilin | 62-53-3 | 184 | -6 | | |
| 3-Fluorbenzonitril | 403-54-3 | 185 | -16 | | |
| 2,5-Dimethylanisol | 1706-11-2 | 190 | ~5 | | |
| 2,4-Dimethylanisol | 6738-23-4 | 191 | n. a. | | |
| Benzonitril | 100-47-0 | 191 | -13 | | |
| 3,5-Dimethylanisol | 874-63-5 | 193 | n. a. | | |
| N,N-Dimethylanilin | 121-69-7 | 194 | 2 | | |
| 1-Fluor-3,5-di-methoxybenzol | 52189-63-6 | ~195 | n. a. | | |
| Phenylacetat | 122-79-2 | 196 | -30 | 0,025 | 0,59 |
| N-Methylanilin | 100-61-8 | 196 | -57 | | |
| Methylbenzoat | 93-58-3 | 198 | -12 | 0,084 | 0,89 |

(fortgesetzt)

| Lösemittel | CAS-Nummer | Siedepunkt [°C] | Schmelzpunkt [°C] | Dampfdruck bei 20°C [torr] | Dampfdruck bei 40°C [torr] |
|---|---|---|---|---|---|
| N-Methylpyrrolidon | 872-50-4 | 199 | -24 | | |
| 3,4-Dimethylanisol | 4685-47-6 | 200 | n. a. | | |
| o-Tolunitril | 529-19-1 | 205 | -13 | | |
| Veratrol | 91-16-7 | 207 | 15 | 0,012 | 0,273 |
| Ethylbenzoat | 93-89-0 | 212 | -34 | 0,022 | 0,348 |
| N,N-Diethylanilin | 91-66-7 | 217 | -38 | | |
| 4-tert-Butyl-anisol | 5396-38-3 | 222 | n. a. | 0,013 | 0,259 |
| Propylbenzoat | 2315-68-6 | 231 | -51 | 0,006 | 0,131 |
| 1-Methylnaphthalin | 90-12-0 | 243 | -22 | 0,004 | 0,092 |
| 3,5-Dimethoxy-toluol | 4179-19-5 | 244 | n. a. | | |
| Butylbenzoat | 136-60-7 | 250 | -22 | 0,0004 | 0,018 |
| 2-Methylbiphenyl | 643-58-3 | 255 | n. a. | | |
| Dimethylnaphthalin (Isomerengemisch) | 28804-88-8 | 262 | n. a. | | |
| 2-Phenyl-pyridin | 1008-89-5 | ~270 | n. a. | | |
| 2,2'-Bitolyl | 605-39-0 | ~300 | n. a. | | |

Die in der Tabelle 1 aufgeführten Lösemittel können keinen Anspruch auf Vollständigkeit erheben. Die Bereitung einer erfindungsgemäßen Lösung ist dem Fachmann ohne Weiteres auch mit anderen hier nicht explizit aufgeführten Lösemitteln ohne erfinderisches Zutun möglich.

Bevorzugt sind also erfindungsgemäße Lösungen, enthaltend als Lösemittel A und B ein oder mehrere Lösemittel ausgewählt aus 3-Fluor-benzotrifluorid, Benzotrifluorid, Dioxan, Trifluormethoxybenzol, 4-Fluor-benzotrifluorid, 3-Fluorpyridin, Toluol, 2-Fluortoluol, 2-Fluor-benzotrifluorid, 3-Fluortoluol, Pyridin, 4-Fluortoluol, 2,5-Difluortoluol, 1-Chlor-2,4-difluorbenzol, 2-Fluorpyridin, 3-Chlorfluorbenzol, 1-Chlor-2,5-difluorbenzol, 4-Chlorfluorbenzol, Chlorbenzol, 2-Chlorfluorbenzol, p-Xylol, m-Xylol, o-Xylol, 2,6-Lutidin, 2-Fluor-m-xylol, 3-Fluor-o-xylol, 2-Chlorbenzotrifluorid, Dimethylformamid, 2-Chlor-6-fluortoluol, 2-Fluoranisol, Anisol, 2,3-Dimethylpyrazin, Brombenzol, 4-Fluoranisol, 3-Fluoranisol, 3-Trifluormethylanisol, 2-Methylanisol, Phenetol, Benzodioxol, 4-Methylanisol, 3-Methylanisol, 4-Fluor-3-methyl-anisol, 1,2-Dichlorbenzol, 2-Fluorbenzonitril, 4-Fluorveratrol, 2,6-Dimethylanisol, Anilin, 3-Fluorbenzonitril, 2,5-Dimethylanisol, 2,4-Dimethylanisol, Benzonitril, 3,5-Dimethylanisol, N,N-Dimethylanilin, 1-Fluor-3,5-dimethoxybenzol, Phenylacetat, N-Methylanilin, Methylbenzoat, N-Methylpyrrolidon, 3,4-Dimethylanisol, o-Tolunitril, 4-tert-Butyl-anisol, Veratrol, Ethylbenzoat, N,N-Diethylanilin, Propylbenzoat, 1-Methylnaphthalin, 3,5-Dimethoxy-toluol, Butylbenzoat, 2-Methylbiphenyl, Dimethylnaphthalin, 2-Phenylpyridin oder 2,2'-Bitolyl.

Als bevorzugte Lösemittel C, die sich als schlechte Lösemittel für eine große Bandbreite organischer oder metallorganischer, oligomerer, polymerer oder dendritischer Halbleiter erwiesen haben, bieten sich geradkettige, verzweigte oder cyclische höhere Alkane, bevorzugt mit sieben oder mehr C-Atomen, an. Hier können auch entsprechende technische Destillationsschnitte gewählt werden. Es kommen auch Terpene, (cyclo)aliphatische Alkohole, Ketone, Carbonsäureester oder einfach oder mehrfach substituierte aromatische Lösemittel, insbesondere substituierte Benzole, Naphthaline und Pyridine, die mit langen Alkyl- oder Alkoxysubstituenten mit 4 oder mehr C-Atomen substituiert sind, in Frage. Weiterhin geeignet sind höhere Alkohole mit mehr als 4 C-Atomen, Glycole oder auch deren Ether, wie beispielsweise Diglyme oder Triglyme.

Besonders bevorzugt sind die in der nachfolgenden Tabelle 2 aufgeführten Lösemittel mit Siedepunkt zwischen 100 und 250 °C, wobei auch hier wiederum gilt, dass die besonders geeigneten Lösemittel für jeden organischen Halbleiter separat bestimmt werden müssen, so dass auch hier diese Tabelle nur als genereller Anhaltspunkt verstanden werden kann. Analog zu Tabelle 1 sind für einige der aufgeführten Lösemittel noch die Dampfdrücke im besonders bevorzugten Temperaturbereich von Beschichtungsverfahren mit aufgenommen.

Tabelle 2: Besonders bevorzugte schlechte Lösemittel C

| Lösemittel | CAS-Nummer | Siedepunkt [°C] | Schmelzpunkt [°C] | Dampfdruck bei 20°C [torr] | Dampfdruck bei 40°C [torr] |
|---|---|---|---|---|---|
| Methylcyclohexan | 108-87-2 | 101 | -127 | | |
| 3-Pentanol | 584-02-1 | 116 | -8 | | |
| cis/trans-1,4-Dimethylcyclohexan | 589-90-2 | 120 | -87 | | |
| cis/trans-1,3-Dimethylcyclohexan | 591-21-9 | 121-124 | n. a. | | |
| Ethylenglycolmonomethylether | 109-86-4 | 124 | -85 | | |
| cis/trans-1,2-Dimethylcyclohexan | 583-57-3 | 124 | n. a. | | |
| Octan | 111-65-9 | 126 | -57 | | |
| 2-Hexanol | 626-93-7 | 136 | n. a. | | |
| 1-Pentanol | 71-41-0 | 138 | -79 | | |
| 1,2,4-Trimethylcyclohexan | 2234-75-5 | 142 | n. a. | | |
| 4-Heptanon | 123-19-3 | 145 | -33 | | |
| 3-Heptanon | 106-35-4 | 148 | -39 | | |
| 2-Heptanon | 110-43-0 | 150 | -35 | | |
| Nonan | 111-84-2 | 151 | -51 | | |
| Cyclohexanon | 108-94-1 | 155 | -47 | | |
| 3-Heptanol | 589-82-2 | 156 | -70 | | |
| 1-Hexanol | 111-27-3 | 157 | -52 | | |
| 2-Heptanol | 543-49-7 | 161 | n. a. | | |
| Diglyme | 111-96-6 | 162 | -64 | | |
| Buttersäurebutylester | 109-21-7 | 165 | n. a. | 1,1 | 5,5 |
| tert-Butylbenzol | 98-06-6 | 169 | -58 | | |
| Decan | 124-18-5 | 174 | -30 | 1,2 | 5,5 |
| 1-Heptanol | 111-70-6 | 176 | -36 | | |
| 2-Octanol | 123-96-6 | 179 | -39 | 0,056 | 0,90 |
| Butylcyclohexan | 1678-93-9 | 180 | -78 | | |
| 2-Ethyl-1-hexanol | 104-76-7 | 185 | -76 | 0,016 | 0,42 |
| Decalin | 91-17-8 | 187 | -31 | 0,18 | 2,2 |
| Propylenglycol | 57-55-6 | 187 | -60 | | |
| Dimethylsulfoxid | 867-68-5 | 189 | 19 | 0,66 | 3,1 |
| 3,3,5-Trimethylcyclohexanon | 873-94-9 | 190 | -10 | | |
| Glycol | 107-21-1 | 198 | -13 | | |
| 3,7-Dimethyl-1-octanol | 106-21-8 | ca. 200 | n. a. | 0,013 | 0,24 |
| 3,7-Dimethyl-3-octanol | 78-69-3 | ca. 200 | n. a. | | |
| Bernsteinsäuredimethylester | 106-65-0 | 200 | 18 | | |
| tert-Butyl-m-xylol | 98-19-1 | 205 | n. a. | 0,015 | 0,36 |
| Benzyl-alkohol | 100-51-6 | 205 | -15 | 0,013 | 0,30 |

(fortgesetzt)

| Lösemittel | CAS-Nummer | Siedepunkt [°C] | Schmelzpunkt [°C] | Dampfdruck bei 20°C [torr] | Dampfdruck bei 40°C [torr] |
|---|---|---|---|---|---|
| DBE (technisches Gemisch aus Bernsteinsäure- und Glutarsäure-dimethylester) | "106-65-0" | 196-215 | n. a. | | |
| Dodecan | 112-40-3 | 215 | -12 | | |
| Bernsteinsäurediethylester | 123-25-1 | 218 | -20 | | |
| Triglyme | 112-49-2 | 220 | -40 | | |
| Bicyclohexyl | 92-51-3 | 227 | 3 | 0,006 | 0,15 |
| Adipinsäuredimethylester | 627-93-0 | 230 | 8 | | |
| 1-Decanol | 112-30-1 | 233 | n. a. | | |
| 2-Pyrrolidon | 616-45-5 | 245 | 25 | | |

Die in Tabelle 2 aufgeführten Lösemittel können keinen Anspruch auf Vollständigkeit erheben. Die Bereitung einer erfindungsgemäßen Lösung ist dem Fachmann ohne Weiteres auch mit anderen hier nicht explizit aufgeführten Lösemitteln ohne erfinderisches Zutun möglich.

Bevorzugt sind also erfindungsgemäße Lösungen, enthaltend als Lösemittel C mindestens ein Lösemittel ausgewählt aus Methylcyclohexan, 3-Pentanol, 1,4-Dimethylcyclohexan, Ethylenglycolmonomethylether, 1,2-Dimethylcyclohexan, Octan, 2-Hexanol, 1-Pentanol, 1,2,4-Trimethylcyclohexan, 4-Heptanon, 3-Heptanon, 2-Heptanon, Nonan, Cyclohexanon, 3-Heptanol, 1-Hexanol, 2-Heptanol, Diglyme, Buttersäurebutylester, tert-Butylbenzol, Decan, 1-Heptanol, 2-Octanol, Butylcyclohexan, 2-Ethyl-1-hexanol, Decalin, Propylenglycol, Dimethylsulfoxid, 3,3,5-Trimethylcyclohexanon, Glycol, 3,7-Dimethyl-1-octanol, 3,7-Dimethyl-3-octanol, Bernsteinsäuredimethylester, tert-Butyl-m-xylol, Benzylalkohol, DBE, Dodecan, Bernsteinsäurediethylester, Triglyme, Bicyclohexyl, Adipinsäuredimethylester, 1-Decanol oder 2-Pyrrolidon.

Um die Erfindung näher zu erläutern sind in Tabelle 3 einige gut verwendbare erfindungsgemäße Lösemittelgemische zusammengestellt. Dies stellt nur einen Anhaltspunkt dar.

Tabelle 3: Beispiele für erfindungsgemäße Lösemittelmischungen

| Lösemittel A | Lösemittel C | Lösemittel B |
|---|---|---|
| o-Xylol | Butyl-cyclohexan | Veratrol |
| Anisol | Butyl-cyclohexan | Methylbenzoat |
| Anisol | Butyl-cyclohexan | 3,4-Dimethyl-anisol |
| Anisol | Decalin | Veratrol |
| Phenethol | Decalin | Veratrol |
| Methyl-anisol | Decalin | Veratrol |
| Anisol | Benzyl-alkohol | Butylbenzoat |
| Anisol | Benzyl-alkohol | Methylnaphthalin |
| Methylanisol | Benzyl-alkohol | Butylbenzoat |
| Anisol | 3,7-Dimethyl-1-octanol | Veratrol |
| Phenethol | 3,7-Dimethyl-1-octanol | Ethylbenzoat |
| Methyl-anisol | 3,7-Dimethyl-1-octanol | Methylnaphthalin |
| Anisol | DBE | Ethylbenzoat |
| Phenethol | DBE | Methylnaphthalin |
| Methylanisol | DBE | Butylbenzoat |

(fortgesetzt)

| Lösemittel A | Lösemittel C | Lösemittel B |
|---|---|---|
| Anisol | t-Butyl-m-xylol | Veratrol |
| Phenethol | t-Butyl-m-xylol | Veratrol |
| Methylanisol | t-Butyl-m-xylol | Veratrol |
| Anisol | Bicyclohexyl | Propyl-benzoat |
| Phenethol | Bicyclohexyl | Propyl-benzoat |
| Methylanisol | Bicyclohexyl | Propyl-benzoat |
| 2,5-Demethylanisol | Bicyclohexyl | Propyl-benzoat |

Eine besonders vorteilhafte Eigenschaft der erfindungsgemäßen Lösungen ist, dass diese beim Eintrocknen (Aufkonzentrieren) sehr schnell eindicken und gelieren. Diese Eigenschaft wird durch die geeignete Wahl der Lösemittel und die geeigneten relativen Siedepunkte bzw. Dampfdrücke, wie oben beschrieben, erzeugt.

Unter einem Gel wird ein formbeständiges, leicht deformierbares, an Flüssigkeiten reiches disperses System aus mindestens 2 Komponenten verstanden, das zumeist aus einem festen Stoff mit langen oder stark verzweigten Teilchen und einer Flüssigkeit als Dispersionsmittel besteht.

Sehr schnelles Eindicken bedeutet in diesem Zusammenhang, dass das Eindicken und Gelieren schneller als gemäß einfacher physikalischer Gesetzmäßigkeiten erfolgt. So besteht für Polymerlösungen im Allgemeinen folgender Zusammenhang zwischen Viskosität $\eta$ und Konzentration c:

$$\eta \sim c^{3.4}$$

Anschaulich bedeutet dies, dass sich bei Verdopplung der Konzentration die Viskosität ca. verzehnfacht. Dies ist ein theoretischer Wert, der in der Praxis aber nicht immer eintritt. Reale Polymerlösungen verändern ihre Viskosität bei Verdopplung der Konzentration um einen Faktor im Bereich von ca. 5 bis 10. Ab einem gewissen Punkt geliert dann die Lösung, d. h. sie wird formbeständig und nicht mehr vollständig fließfähig.

Sehr schnelles Eindicken bzw. Gelieren bedeutet also, dass sich bei einer Verdopplung der Konzentration, wie beim Eintrocknen eines gedruckten Films bzw. Pixels, die Viskosität um mehr als einen Faktor 10 erhöht.

Dieser Effekt kann überraschend bei den erfindungsgemäßen Lösungen in bevorzugter Ausführung besonders ausgeprägt gefunden werden (vgl. z. B. die Lösungen 4 bis 6 in Beispiel 1.2, 7 bis 9 in Beispiel 2.2, 10 bis 12 in Beispiel 2.3). Gerade dieser Effekt scheint bei der Behebung der vorne beschriebenen Probleme 2, 3, 4 und 6 von besonderer Bedeutung zu sein.

Zum Herstellen der Lösungen wird der organische Halbleiter bzw. Blend in der gewünschten Konzentration in dem gewünschen Lösemittelgemisch gelöst. Es kann auch sinnvoll sein, den organischen Halbleiter bzw. Blend erst in einem Teil der Lösemittel, beispielsweise einer Mischung aus den Lösemitteln A und B, zu lösen und zu dieser Lösung dann das/die restlichen Lösemittel, beispielsweise das Lösemittel C, zuzugeben. Da organische Halbleiter bzw. deren Lösungen teilweise gegenüber Sauerstoff bzw. anderen Luftbestandteilen nicht stabil sind, kann es sinnvoll sein, diesen Vorgang unter einer inerten Atmosphäre, beispielsweise unter Stickstoff oder Argon, durchzuführen. Es kann auch sinnvoll sein, den Lösevorgang beispielsweise durch Erhitzen und/oder Rühren zu beschleunigen. Aggregate des organischen Halbleiters bzw. des Matrixpolymers können dabei auch beispielsweise durch äußere mechanische Einwirkung, zum Beispiel durch Ultraschall, wie beschrieben in WO 03/019694, zerkleinert werden. Ebenso kann sich der Zusatz weiterer Additive, wie beispielsweise beschrieben in WO 03/019693, für die Anwendung als sinnvoll erweisen. Es hat sich weiterhin als sinnvoll erwiesen, vor Anwendung der Lösungen diese zu filtrieren, um sie von beispielsweise kleineren Mengen vernetzter Bestandteile oder von Staubpartikeln zu reinigen.

Die hier beschriebenen Lösungen zeigen überraschende Verbesserungen auf den oben genannten Problemfeldern.

So führt die Verwendung von Lösemitteln im bevorzugten Siedebereich dazu, dass die Lösungen im Druckkopf bzw. an den Düsen nicht zu schnell eintrocknen (Problem 1). Zwar bieten hier noch höher siedende Lösemittel weitere Verbesserungen, diese weisen dann aber besonders bei den Problemen 3 bis 5 überproportional starke Nachteile auf. Es hat sich hier als sehr sinnvoll erwiesen, Lösemittel im beschriebenen Siedepunktsbereich einzusetzen.

Auch bei Problem 2 werden deutliche Verbesserungen erzielt. So zeigen Blendmaterialien in Filmen oder Pixeln, die aus erfindungsgemäßen Lösungen erzeugt wurden, keinerlei Inhomogenitäten in der Elektrolumineszenz. Ohne an eine bestimmte Theorie gebunden sein zu wollen, vermuten wir, dass durch das schnelle Eindicken der Lösung beim Trocknen ein Entmischen der Blends weitgehend verhindert wird, wodurch eine homogenere Materialverteilung im Film ermöglicht wird.

Für das Problem 3 wurde ein erheblicher Fortschritt erzielt, indem ternäre Lösemittelmischungen mit den beschriebenen Löslichkeitseigenschaften und relativen Siedepunkten bzw. Dampfdrücken verwendet werden. Dadurch erhält man, wie oben beschrieben, beim Eindampfen sehr schnell eine sehr hohe Viskosität im Pixel bzw. Film, die der Ausbildung der inhomogenen Materialverteilung entgegenwirkt.

Problem 4 und Problem 5 werden deutlich besser gelöst als mit höher siedenden Lösemitteln. Insbesondere bei Problem 4 konnten durch das sehr schnelle Eindicken der Lösung besonders deutliche Effekte erzielt werden.

Beim Eintrocknen der erfindungsgemäßen Lösungen fällt der organische Halbleiter nicht aus der Lösung aus, so dass hiermit auch das Problem 6 als gelöst zu betrachten ist. Ohne an die Richtigkeit einer bestimmten Theorie gebunden sein zu wollen, vermuten wir, dass durch Zusatz eines geringen Anteils eines guten Lösemittels B, das einen höheren Siedepunkt bzw. niedrigeren Dampfdruck (bei der Auftragungstemperatur) aufweist als das schlechte Lösemittel C, ein Niederschlag des organischen Halbleiters beim Trocknungsvorgang verhindert werden kann. Dies wurde bisher so nicht in der Literatur beschrieben und führt überraschend zu deutlich homogeneren Filmen, als dies mit binären oder ternären Lösemittelsystemen der Fall ist, bei denen der organische Halbleiter bzw. andere Blendbestandteile im höchstsiedenden Lösemittel die geringste Löslichkeit aufweist. Die Probleme 2 bis 5 könnten prinzipiell auch durch das Verwenden wirklich niedrig siedender Lösemittel (oder Lösemittelgemische) gelöst werden. Diese bereiten aber für Problem 1 und Problem 6 technisch nicht lösbare Schwierigkeiten. Somit sind gerade Lösemittelgemische mit unterschiedlichen Löslichkeitseigenschaften und unterschiedlichen Siedepunkten eine optimale Lösung für diese Problembereiche. Die Probleme 1 bis 6 in Kombination können nicht sinnvoll mit einem einzigen Lösemittel gelöst werden. Wird ein zu niedrig siedendes Lösemittel verwendet, sind die Probleme 1 und 6 nicht zu lösen, wird ein zu hoch siedendes Lösemittel verwendet, werden Probleme 3 bis 5 immer schwerer lösbar.

Im vorliegenden Anmeldetext und auch in den im Weiteren folgenden Beispielen wird vor allem auf erfindungsgemäße Lösungen zur Herstellung polymerer Leuchtdioden und die entsprechenden Displays abgezielt. Trotz dieser Beschränkung der Beschreibung ist es für den Fachmann ohne weiteres erfinderisches Zutun möglich, entsprechende erfindungsgemäße Lösungen auch für die Herstellung anderer organischer elektronischer Vorrichtungen anzuwenden, z. B. für organische Feld-Effekt-Transistoren (O-FETs), organische Dünnfilmtransistoren (O-TFTs), organische integrierte Schaltungen (O-ICs), organische Solarzellen (O-SCs) oder auch organische Laserdioden (O-Laser), um nur einige Anwendungen zu nennen.

Organische elektronische Vorrichtungen, enthaltend mindestens eine erfindungsgemäße Schicht, die unter Verwendung einer erfindungsgemäßen Lösung und/oder eines erfindungsgemäßen Verfahrens erhalten wurde, sind bevorzugt ausgewählt aus der Gruppe der polymeren Leuchtdioden (PLEDs), organischen Feld-Effekt-Transistoren (O-FETs), organischen Dünnfilmtransistoren (O-TFTs), organischen integrierten Schaltungen (O-ICs), organischen Solarzellen (O-SCs) und organischen Laserdioden (O-Laser).

Die vorliegende Erfindung wird durch die folgenden Beispiele näher erläutert, ohne sie darauf einschränken zu wollen. Der Fachmann kann aus der Beschreibung und den aufgeführten Beispielen ohne erfinderisches Zutun weitere erfindungsgemäße Lösungen bereiten und diese anwenden, um daraus Schichten zu erzeugen.

**Beispiele**

**Beispiel 1:** Lösungen des Polymers POLY1 in Mischungen von Anisol, 4-Methylanisol (jeweils Lösemittel A), Veratrol (Lösemittel B) und Decalin (Lösemittel C):

1.1 Eingesetzte Materialien:

- Polymer POLY1 ist ein Polymer gemäß dem Beispiel P17 in WO 02/077060, gemäß der geordneten Variante gemäß Beispiel P1 aus DE 10337077.3. Der hier verwendete Ansatz POLY1-B6 hat ein $M_w$ von 220k g/mol, ein $M_n$ von 70k g/mol und ein Mp von 180k g/mol. Ein Lösung mit 14 g/L in Anisol/o-Xylol weist eine Viskosität (bei 500 s$^{-1}$) von ca. 6.6 mPas auf.
- Lösemittel:

  - Anisol; Siedepunkt 154 °C; Löslichkeit POLY1-B6 > 30 g/L.
  - 4-Methyl-anisol; Siedepunkt 174 °C; Löslichkeit POLY1-B6 > 30 g/L.
  - Veratrol: Siedepunkt 207 °C; Löslichkeit POLY1-B6 > 30 g/L.
  - Decalin (Isomerengemisch): Siedepunkt 187 °C; Löslichkeit POLY1-B6 < 0.05 g/L.

1.2 Lösungsbereitung und grundlegende Eigenschaften:

• Es wurden verschiedene Mischungen mit den o. g. Lösemitteln und dem genannten Polymer angesetzt. Alle Lösungen enthielten das Polymer mit ca. 11 g/L. Die Lösungen sind in Tabelle 4 genauer spezifiziert:

Tabelle 4: Zusammensetzungen verschiedener Lösungen

| Nummer | Anisol (vol%) | Me-Anisol (vol%) | Veratrol (vol%) | Decalin (vol%) | Erfindungsgemäß? | Gemäß Stand der Technik? |
|--------|---------------|------------------|-----------------|----------------|------------------|--------------------------|
| Lösung 1 | 50 | | 0 | 50 | NEIN | WO 02/069119 |
| Lösung 2 | 0 | | 50 | 50 | NEIN | NEIN |
| Lösung 3 | 40 | 10 | 0 | 50 | NEIN | WO 02/072714 |
| Lösung 4 | 40 | | 10 | 50 | JA | NEIN |
| Lösung 5 | 30 | | 10 | 60 | JA | NEIN |
| Lösung 6 | 34 | | 6 | 60 | JA | NEIN |

• Die Lösungen wurden anschließend langsam eingedampft und das Verhalten der Lösungen bzgl. Konzentration-Viskositäts-Verlauf bzw. sonstiger Eigenschaften verfolgt. Diese Ergebnisse sind in Tabelle 5 zusammengefasst.

Tabelle 5: Verhalten der Lösungen beim Aufkonzentrieren

| | Viskosität (@ 500 s$^{-1}$) | | | | |
|---------|---------|-----------|-----------|-----------|--------------------------------|
| Nummer | 11 g/L | $\sim$ 20 g/L | $\sim$ 30 g/L | $\sim$ 40 g/L | Bemerkungen |
| Lösung 1 | 6.3 | 53.8 | n. a. | n. a. | Polymer fällt bei ca. 25 g/L aus |
| Lösung 2 | 8.0 | 42.0 | 108 | 255 | Kein starkes Eindicken. |
| Lösung 3 | 6.5 | 55.3 | n. a. | n. a. | Polymer fällt bei ca. 25 g/L aus |
| Lösung 4 | 7.4 | 78.2 | 367 | 925 | Starkes Eindicken |
| Lösung 5 | 7.4 | 249 | $\sim$1200 | >5000 | Sehr starkes Eindicken |
| Lösung 6 | 7.4 | 263 | $\sim$1300 | >5000 | Sehr starkes Eindicken. |

• Die Lösungen gemäß dem Stand der Technik (Lösung 1 und Lösung 3; jeweils das höchstsiedende Lösemittel besitzt die niedrigste Löslichkeit für das verwendete Polymer) zeigen für die Anwendung unbrauchbares Verhalten. Das Polymer fällt aus. Eine vernünftige Filmbildung kann so nicht erreicht werden.
• Die Lösung 2 zeigt keine besonderen Effekte bzgl. dem Eindick-Verhalten.
• Die erfindungsgemäßen Lösungen zeigen deutliche Effekte bzgl. dem Eindick-Verhalten.

1.3 Untersuchungen bzgl. Druckbarkeit und Filmbildung:

Die o. g. Lösung 6 wurde noch genauer bzgl. ihrer Anwendbarkeit beim IJ-Drucken untersucht.
Die Lösung zeigte eine Oberflächenspannung von ca. 31.5 Dyn/cm.
Die Lösung wurde durch einen Spectra SX-128 Druckkopf (Fa. Spectra, USA) gedruckt. Die Druckbedingungen konnten relativ leicht optimiert werden.
Es wurden folgende Ergebnisse erhalten:

• Die Tropfenmasse ist im geeigneten Bereich linear von der verwendeten Spannung abhängig (ca. 7 ng bei 45 V, ca. 10 ng bei 50 V, ca. 13 ng bei 55 V).
• Die Tropfengeschwindigkeit ist ebenfalls linear von der Spannung abhängig (ca. 3 m/s bei 45 V, ca. 4 m/s bei 50 V, ca. 5 m/s bei 55 V).
• Der Druckkopf konnte problemlos im Bereich von ca. 1000 bis fast 10000 Hertz betrieben werden.
• Einfache optimierte Druckbedingungen waren die folgenden: 50 V; Pulsweite 5 $\mu$s; 1 kHz Druckfrequenz.
• Die Tropfen zeigten kurze Ligamente, die jedoch sehr schnell wieder in die Tropfen zurückgezogen wurden; dies geschah (durchschnittlich) innerhalb der ersten 475 $\mu$m; d. h. Drucken mit einem Abstand ab 0.5 mm ist problemlos möglich. Darüber hinaus konnten auch keine Probleme mit Satellitenbildung gefunden werden.

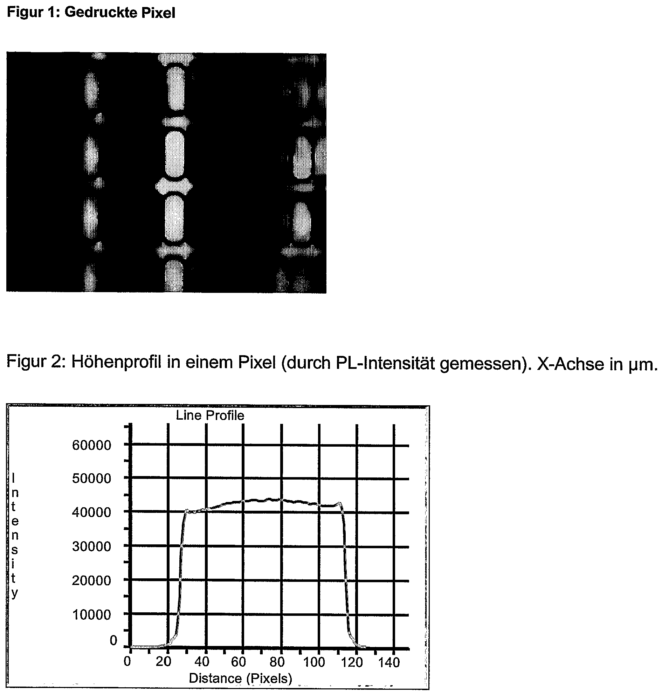

Die Lösung 6 wurde dann mit den optimierten Bedingungen in ein strukturiertes Substrat (mit $CF_4/O_2$-Plasma behandelten Partitionierungen) gedruckt. Es wurde dort eine sehr gute (homogene) Filmbildung erreicht. Dies ist in den beiden folgenden Abbildungen 1 und 2 wiedergegeben. Die einzelnen Pixel hatten dabei eine Größe von ca. 66 $\mu$m x 175 $\mu$m. Pro Pixel wurden 10 Tropfen aus ca. 2 mm Entfernung abgegeben.

Es wurden folgende Punkte beobachtet:

• Die Druckbarkeit der Lösung 6 stellte sich als sehr gut heraus, d. h. deutlich vorteilhafter als der Stand der Technik.

• Unter optimierten Bedingungen konnten sehr homogene Filme erhalten werden.

1.4 Untersuchung bzgl. der Anwendung in der EL:

Lösung 6 wurde bezüglich der Verwendung in der Elektrolumineszenz untersucht. Zum Vergleich wurde auch eine Lösung in Toluol als Referenz parallel dazu vermessen. Die PLEDs wurden jeweils via Spin-Coaten hergestellt (ein allgemeines Verfahren dazu ist beispielsweise in der o. g. WO 02/072714 ausgeführt). Beide Lösungen wurden während des Spin-Coatens mit einem NIR-Trocknungsgerät behandelt, da gerade Lösung 6 sonst sehr lange zum Trocknen benötigt (vgl. auch: WO 03/038923).

Beide Lösungen ergaben (optisch) sehr schöne homogene Schichten.

Die EL-Evaluierung ist in Tabelle 6 gegenübergestellt:

Tabelle 6: EL-Evaluierung

| | | Spannung [V] | | | | | | |
|---|---|---|---|---|---|---|---|---|
| Lösung | | 2.8 | 3.0 | 3.2 | 3.4 | 3.6 | 3.8 | 4.0 |
| #6 (gem. Erfindung) | j [mA/cm$^2$] | 0.97 | 2.93 | 6.43 | 11.8 | 19.1 | 28.8 | 41.4 |
| | L [cd/m$^2$] | 48 | 158 | 352 | 639 | 1030 | 1500 | 2100 |
| | Eff. [cd/A] | 5.0 | 5.4 | 5.4 | 5.4 | 5.4 | 5.2 | 5.0 |
| | | | | | | | | |
| in Toluol (Referenz) | j [mA/cm$^2$] | 0.20 | 0.52 | 1.1 | 1.9 | 3.2 | 5.0 | 8.6 |
| | L [cd/m$^2$] | 3 | 23 | 52 | 100 | 168 | 264 | 469 |
| | Eff. [cd/A] | 1.5 | 4.6 | 4.7 | 5.2 | 5.3 | 5.3 | 5.4 |

Die PLEDs aus beiden Lösungen zeigten die gleiche Farbe (hellblau; CIE-1931-Koordinaten: X $\sim$ 0.18, Y $\sim$ 0.27).

Lebensdauermessungen ergaben, dass das Device aus der Lösung 6 etwa doppelt so lange bei vergleichbarer Helligkeit lebten (ca. 3000 h bei 100 Cd/m$^2$ gegenüber ca. 1500 h aus der Toluol-Lösung).

Zusammengefasst wurde so folgende überraschende Vorteile erhalten:

• Die Filmbildung ist auch aus einem einfachen Beschichtungsverfahren (Spin-Coaten) sehr gut.
• Die Morphologie der erzeugten Schicht ist deutlich anders gegenüber dem Stand der Technik. Die damit erzeugten PLEDs zeigen deutlich steilere Strom-Spannungskennlinien (und damit auch deutlich höhere Helligkeiten bei gleicher Spannung).
• Überraschend wird dadurch auch die operative Lebensdauer positiv beeinflusst.

**Beispiel 2:** Lösungen des Polymers POLY1 in Mischungen von Anisol, Phenethol, 4-Methylanisol (jeweils Lösemittel A), Veratrol (Lösemittel B) und *t*-Butyl-m-xylol (Lösemittel C):

2.1 Eingesetzte Materialien:

• Polymer POLY1 ist das bereits in Beispiel 1 beschriebene Polymer. Der hier verwendete Ansatz POLY1-B7 hat ein

$M_w$ von 325k g/mol, ein $M_n$ von 100k g/mol und ein Mp von 275k g/mol. Ein Lösung mit 14 g/L in Anisol/o-Xylol weist eine Viskosität (bei 500 s$^{-1}$) von ca. 10.1 mPas auf.

- Lösemittel:

  - Anisol; Siedepunkt 154 °C; Löslichkeit POLY1-B7 > 30 g/L.
  - Phenethol; Siedepunkt 170 °C; Löslichkeit POLY1-B7 > 30 g/L.
  - 4-Methyl-anisol; Siedepunkt 174 °C; Löslichkeit POLY1-B7 > 30 g/L.
  - Veratrol: Siedepunkt 207 °C; Löslichkeit POLY1-B7 > 30 g/L.
  - t-Butyl-m-xylol: Siedepunkt 205 °C; Löslichkeit POLY1-B7 < 1 g/L.

2.2 Lösungsbereitung und grundlegende Eigenschaften:

- Es wurden verschiedene erfindungsgemäße Mischungen mit den o. g. Lösemitteln und dem genannten Polymer angesetzt. Alle Lösungen enthielten das Polymer mit ca. 10 g/L. Die Lösungen sind in Tabelle 7 genauer spezifiziert:

Tabelle 7: Zusammensetzungen verschiedener Lösungen

| Nummer | Anisol (vol%) | Phenethol (vol%) | Me-Anisol (vol%) | Veratrol (vol%) | t-Butyl-m-xylol (vol%) |
|---|---|---|---|---|---|
| Lösung 7 | 20 | | | 4 | 76 |
| Lösung 8 | | 11 | | 4 | 85 |
| Lösung 9 | | | 10 | 4 | 86 |

- Die Lösungen wurden anschließend langsam eingedampft und das Verhalten der Lösungen bzgl. Konzentration-Viskositäts-Verlauf bzw. sonstiger Eigenschaften verfolgt. Diese Ergebnisse sind in Tabelle 8 zusammengefasst.

Tabelle 8: Verhalten der Lösungen beim Aufkonzentrieren

| | Viskosität (@ 40 s$^{-1}$) | | | | |
|---|---|---|---|---|---|
| Nummer | ~10 g/L | ~14 g/L | ~20 g/L | ~25 g/L | Bemerkungen |
| Lösung 7 | 10.3 | 33.3 | 1026 | 2500 | Sehr starkes Eindicken |
| Lösung 8 | 11.2 | 37.9 | 950 | 5000 | Sehr starkes Eindicken |
| Lösung 9 | 11.2 | 46.3 | 897 | 3500 | Sehr starkes Eindicken. |

- Wie in Beispiel 1 zeigen die erfindungsgemäßen Lösungen deutliche Effekte bzgl. dem Eindick-Verhalten.

2.3 Untersuchungen bzgl. Druckbarkeit und Filmbildung:

Die Lösungen 7 bis 9 wurden auf Ihre Druckeigenschaften untersucht.

- Die Tropfenmasse und die Tropfengeschwindigkeit waren - wie auch im Beispiel 1 - jeweils linear von der verwendeten Spannung abhängig.
- Der Druckkopf konnte problemlos im Bereich von ca. 1000 bis (je nach Lösung) 5000 bzw. 7000 Hertz betrieben werden.
- Einfache optimierte Druckbedingungen waren die folgenden: 65 V; Pulsweite 5 $\mu$s; 1 kHz Druckfrequenz.
- Die Tropfen zeigten kurze Ligamente, die jedoch sehr schnell wieder in die Tropfen zurückgezogen wurden; dies geschah (durchschnittlich) innerhalb der ersten 250 $\mu$m; d. h. Drucken mit einem Abstand ab 0.5 mm ist problemlos möglich.

Das Drucken in Substrate (analog den Angaben im Beispiel 1) ergab, bei einem Druckabstand von 1 mm homogene Filme.

**Beispiel 3:** Lösungen des Polymers POLY1 in Mischungen von Anisol, 4-Methylanisol, 2,5-Dimethyl-anisol (jeweils Lösemittel A), Propylbenzoat (Lösemittel B) und Bicyclohexyl (Lösemittel C):

3.1 Eingesetzte Materialien:

- Polymer POLY1 ist das bereits in Beispiel 1 beschriebene Polymer. Der hier verwendete Ansatz POLY1-B7 wurde in Beispiel 2 genau beschrieben.
- Lösemittel:

  - Anisol; Siedepunkt 154 °C; Löslichkeit POLY1-B7 > 30 g/L.
  - 4-Methyl-anisol; Siedepunkt 174 °C; Löslichkeit POLY1-B7 > 30 g/L.
  - 2,5-Dimethyl-anisol; Siedepunkt 190 °C; Löslichkeit POLY1-B7 > 30 g/L.
  - Propylbenzoat: Siedepunkt 231 °C; Löslichkeit POLY1-B7 > 30 g/L.
  - Bicyclohexyl: Siedepunkt 227 °C; Löslichkeit POLY1-B7 < 0.1 g/L.

3.2 Lösungsbereitung und grundlegende Eigenschaften:

• Es wurden verschiedene erfindungsgemäße Mischungen mit den o. g. Lösemitteln und dem genannten Polymer angesetzt. Alle Lösungen enthielten das Polymer mit ca. 10 g/L. Die Lösungen sind in Tabelle 9 genauer spezifiziert:

Tabelle 9: Zusammensetzungen verschiedener Lösungen

| Nummer | Anisol (vol%) | Me-Anisol (vol%) | 2,5-Dimethyl-anisol (vol%) | Propylbenzoat (vol%) | Bicyclohexyl (vol%) |
|---|---|---|---|---|---|
| Lösung 10 | 38 | | | 26 | 36 |
| Lösung 11 | | 20 | | 33 | 47 |
| Lösung 12 | | | 21 | 31 | 48 |

• Die Lösungen wurden anschließend langsam eingedampft und das Verhalten der Lösungen bzgl. Konzentration-Viskositäts-Verlauf bzw. sonstiger Eigenschaften verfolgt. Diese Ergebnisse sind in Tabelle 10 zusammengefasst.

Tabelle 10: Verhalten der Lösungen beim Aufkonzentrieren

| | Viskosität (@ 40 $s^{-1}$) | | | | |
|---|---|---|---|---|---|
| Nummer | ~10 g/L | ~14 g/L | ~20 g/L | ~30 g/L | Bemerkungen |
| Lösung 10 | 9.2 | 20.5 | 2050 | 10000 | Sehr starkes Eindicken |
| Lösung 11 | 13.4 | 53.7 | 1550 | 9400 | Sehr starkes Eindicken |
| Lösung 12 | 16.5 | 76.6 | 1260 | 12300 | Sehr starkes Eindicken. |

• Wie in Beispiel 1 und 2 zeigen die erfindungsgemäßen Lösungen deutliche Effekte bzgl. dem Eindick-Verhalten.

3.3 Untersuchungen bzgl. Druckbarkeit und Filmbildung:

Die Lösung 10 wurde intensiv bezüglich Ihrer Druckeigenschaften untersucht.

- Die Tropfenmasse und die Tropfengeschwindigkeit waren - wie auch im Beispiel 1 - jeweils linear von der verwendeten Spannung abhängig.
- Der Druckkopf konnte problemlos im Bereich von ca. 1000 bis 10000 Hertz betrieben werden.
- Einfache optimierte Druckbedingungen waren die folgenden: 60 V; Pulsweite 5 µs; 1 kHz Druckfrequenz.
- Die Tropfen zeigten kurze Ligamente, die jedoch sehr schnell wieder in die Tropfen zurückgezogen wurden; dies geschah (durchschnittlich) innerhalb der ersten 250 µm; d. h. Drucken mit einem Abstand ab 0.5 mm ist problemlos möglich.
- Die Düsenplatte wurde durch diese Tinte nicht benetzt (d. h. es gab keinerlei Anzeichen von Polymerablagerungen).

Das Drucken in Substrate (analog den Angaben im Beispiel 1) ergab, bei einem Druckabstand von 0.5 mm, homogene Filme.

**Patentansprüche**

1.  Einphasige, flüssige Zusammensetzungen (Lösungen), enthaltend

    • mindestens einen organischen Halbleiter, der mindestens eine hochmolekulare Komponente enthält,
    • und mindestens ein organisches Lösemittel A,
    • und mindestens ein organisches Lösemittel B,
    • und mindestens ein organisches Lösemittel C,

    **dadurch gekennzeichnet,**

    • **dass** der organische Halbleiter in dem reinen Lösemittel A bzw. in dem reinen Lösemittel B in einer Konzentration von mindestens 5 g/L bei Raumtemperatur löslich ist,
    • **dass** die Löslichkeit des organischen Halbleiters in dem reinen Lösemittel C bei Raumtemperatur kleiner als 0.3 g/L ist,
    • **dass** der Siedepunkt aller drei Lösemittel A, B und C kleiner als 270°C ist, und
    • **dass** für die Siedepunkte (Sdp.) der Lösemittel A, B, und C gilt, das Sdp.(A) < Sdp.(C) < Sdp.(B) ist und/oder für die jeweiligen Dampfdrücke (p) bei der Temperatur des Beschichtungsverfahrens der Lösemittel A, B und C gilt, dass p (A) > p (C) > p (B).

2.  Lösungen gemäß Anspruch 1, **dadurch gekennzeichnet, dass** der organische Halbleiter als Reinkomponente eingesetzt wird.

3.  Lösungen gemäß Anspruch 1 und/oder 2, **dadurch gekennzeichnet, dass** der organische Halbleiter als Mischung von zwei oder mehreren Komponenten eingesetzt wird.

4.  Lösungen gemäß Anspruch 3, **dadurch gekennzeichnet, dass** ein oder mehrere organische Nicht-Leiter als Matrix verwendet werden.

5.  Lösungen gemäß einem oder mehreren der Ansprüche 1 bis 4, **dadurch gekennzeichnet, dass** die hochmolekulare Komponente ein Molekulargewicht $M_w$ von größer 50000 g/mol besitzt.

6.  Lösungen gemäß einem oder mehreren der Ansprüche 1 bis 5, **dadurch gekennzeichnet, dass** als polymere organische Halbleiter in organischen Lösemitteln lösliche, substituierte Poly-p-arylen-vinylene (PAV), Polyfluorene (PF), Poly-spirobifluorene (PSF), Poly-para-phenylene (PPP) oder -biphenylene, Poly-dihydrophenanthrene (PDHP), cis- und trans-Poly-indenofluorene (PIF), Polythiophene (PT), Polypyridine (PPy), Copolymere, die Struktureinheiten von zwei oder mehr der oben genannten Klassen aufweisen, allgemein konjugierte Polymere, Polyvinyl-carbazole (PVK), Poly-triarylamine und/oder lösliche Polymere, welche phosphoreszierende Einheiten enthalten, eingesetzt werden.

7.  Lösungen gemäß einem oder mehreren der Ansprüche 1 bis 6, **dadurch gekennzeichnet, dass** nicht-leitende Polymere (Matrix-Polymere), welche niedermolekulare, oligomere, dendritische oder polymere organische und/oder metallorganische Halbleiter beigemischt enthalten, verwendet werden.

8.  Lösungen gemäß einem oder mehreren der Ansprüche 1 bis 7, **dadurch gekennzeichnet, dass** der Siedepunkt aller drei Lösemittel A, B und C größer als 120 °C ist.

9.  Lösungen gemäß einem oder mehreren der Ansprüche 1 bis 8, **dadurch gekennzeichnet, dass** die Differenz der Siedepunkte zwischen dem Lösemittel A und dem Lösemittel C mehr als 10 K beträgt.

10. Lösungen gemäß einem oder mehreren der Ansprüche 1 bis 9, **dadurch gekennzeichnet, dass** die Differenz der Siedepunkte zwischen dem Lösemittel C und dem Lösemittel B mehr als 10 K beträgt.

11. Lösungen gemäß einem oder mehreren der Ansprüche 1 bis 10, **dadurch gekennzeichnet, dass** der Anteil des Lösemittels A 10 bis 80 Vol.%, der Anteil des Lösemittels B 0.5 bis 40 Vol.% und der Anteil des Lösemittels C 10 bis 90 Vol.% beträgt.

12. Lösungen gemäß Anspruch 11, **dadurch gekennzeichnet, dass** der Anteil des Lösemittels A 25 bis 60 Vol.%, der Anteil des Lösemittels B 2 bis 20 Vol.% und der Anteil des Lösemittels C 30 bis 70 Vol.% beträgt.

13. Lösungen gemäß einem oder mehreren der Ansprüche 1 bis 12, **dadurch gekennzeichnet, dass** zusätzlich zu den Lösemitteln A, B und C noch weitere gute und/oder schlechte Lösemittel verwendet werden, wobei es sich um jeweils zwei oder mehrere Lösemittel vom Typ A und/oder Typ B und/oder Typ C handelt.

14. Lösungen gemäß einem oder mehreren der Ansprüche 1 bis 13, **dadurch gekennzeichnet, dass** als Lösemittel A und/oder B einfach oder mehrfach substituierte aromatische Lösemittel, Ameisensäurederivate, N-Alkyl-Pyrrolidone oder hochsiedende Ether verwendet werden.

15. Lösungen gemäß Anspruch 14, **dadurch gekennzeichnet, dass** als Lösemittel A und/oder B ein oder mehrere Lösemittel ausgewählt sind aus 3-Fluor-benzotrifluorid, Benzotrifluorid, Dioxan, Trifluormethoxybenzol, 4-Fluor-benzotrifluorid, 3-Fluorpyridin, Toluol, 2-Fluortoluol, 2-Fluor-benzotrifluorid, 3-Fluortoluol, Pyridin, 4-Fluortoluol, 2,5-Difluortoluol, 1-Chlor-2,4-difluorbenzol, 2-Fluorpyridin, 3-Chlorfluorbenzol, 1-Chlor-2,5-difluorbenzol, 4-Chlorfluorbenzol, Chlorbenzol, 2-Chlorfluorbenzol, p-Xylol, m-Xylol, o-Xylol, 2,6-Lutidin, 2-Fluor-m-xylol, 3-Fluor-o-xylol, 2-Chlorbenzotrifluorid, Dimethylformamid, 2-Chlor-6-fluortoluol, 2-Fluoranisol, Anisol, 2,3-Dimethylpyrazin, Brombenzol, 4-Fluoranisol, 3-Fluoranisol, 3-Trifluormethylanisol, 2-Methylanisol, Phenetol, Benzodioxol, 4-Methylanisol, 3-Methylanisol, 4-Fluor-3-methyl-anisol, 1,2-Dichlorbenzol, 2-Fluorbenzonitril, 4-Fluorveratrol, 2,6-Dimethylanisol, Anilin, 3-Fluorbenzonitril, 2,5-Dimethylanisol, 2,4-Dimethylanisol, Benzonitril, 3,5-Dimethylanisol, N,N-Dimethylanilin, 1-Fluor-3,5-dimethoxybenzol, Phenylacetat, N-Methylanilin, Methylbenzoat, N-Methylpyrrolidon, 3,4-Dimethylanisol, Acetophenon, o-Tolunitril, 4-tert-Butyl-anisol, Veratrol, Ethylbenzoat, N,N-Diethylanilin, Propylbenzoat, 1-Methylnaphthalin, 3,5-Dimethoxy-toluol, Butylbenzoat, 2-Methylbiphenyl, Dimethylnaphthalin, 2-Phenyl-pyridin oder 2,2'-Bitolyl.

16. Lösungen gemäß einem oder mehreren der Ansprüche 1 bis 15, **dadurch gekennzeichnet, dass** als Lösemittel C geradkettige, verzweigte oder cyclische höhere Alkane, bevorzugt mit sieben oder mehr C-Atomen, Terpene, (cyclo)aliphatische Alkohole, Ketone, Carbonsäureester oder einfach oder mehrfach substituierte aromatische Lösemittel, die mit langen Alkyl- oder Alkoxysubstituenten mit 4 oder mehr C-Atomen substituiert sind, höhere Alkohole mit mehr als 4 C-Atomen, Glycole oder deren Ether verwendet werden.

17. Lösungen gemäß Anspruch 16, **dadurch gekennzeichnet, dass** mindestens ein Lösemittel C ausgewählt ist aus Methylcyclohexan, 3-Pentanol, 1,4-Dimethylcyclohexan, Ethylenglycolmonomethylether, 1,2-Dimethylcyclohexan, Octan, 2-Hexanol, 1-Pentanol, 1,2,4-Trimethylcyclohexan, 4-Heptanon, 3-Heptanon, 2-Heptanon, Nonan, Cyclohexanon, 3-Heptanol, 1-Hexanol, 2-Heptanol, Diglyme, Buttersäurebutylester, tert-Butylbenzol, Decan, 1-Heptanol, 2-Octanol, Butylcyclohexan, 2-Ethyl-1-hexanol, Decalin, Propylenglycol, Dimethylsulfoxid, 3,3,5-Trimethylcyclohexanon, Glycol, 3,7-Dimethyl-1-octanol, 3,7-Dimethyl-3-octanol, Bernsteinsäuredimethylester, tert-Butyl-m-xylol, Benzyl-alkohol, DBE, Dodecan, Bernsteinsäurediethylester, Triglyme, Bicyclohexyl, Adipinsäuredimethylester, 1-Decanol oder 2-Pyrrolidon, wobei DBE als ein technisches Gemisch aus Bernsteinsäure- und Glutarsäure-dimethylester definiert ist.

18. Verwendung von Lösungen gemäß einem oder mehreren der Ansprüche 1 bis 17, zur Erzeugung von Schichten der organischen Halbleiter auf einem Substrat.

19. Verfahren zur Herstellung organischer Halbleiterschichten auf einem Substrat, **dadurch gekennzeichnet, dass** eine Lösung gemäß einem oder mehreren der Ansprüche 1 bis 17 mittels eines Druckverfahrens verarbeitet wird.

20. Verfahren gemäß Anspruch 19, **dadurch gekennzeichnet, dass** es sich bei dem Druckverfahren um ein Tintenstrahl-Druckverfahren (IJP) handelt.

**Claims**

1. Single-phase, liquid compositions (solutions) comprising

   • at least one organic semiconductor which comprises at least one high-molecular-weight component,

- and at least one organic solvent A,
- and at least one organic solvent B,
- and at least one organic solvent C,

**characterised in that**

- the organic semiconductor is soluble in pure solvent A or in pure solvent B in a concentration of at least 5 g/l at room temperature,
- the solubility of the organic semiconductor in pure solvent C at room temperature is less than 0.3 g/l,
- the boiling point of all three solvents A, B and C is less than 270°C, and
- the following applies to the boiling points (b.p.) of solvents A, B and C: b.p.(A) < b.p.(C) < b.p.(B), and/or to the respective vapour pressures (p) at the temperature of the coating method of solvents A, B and C: p (A) > p (C) > p (B).

2. Solutions according to Claim 1, **characterised in that** the organic semiconductor is employed as pure component.

3. Solutions according to Claim 1 and/or 2, **characterised in that** the organic semiconductor is employed as a mixture of two or more components.

4. Solutions according to Claim 3, **characterised in that** one or more organic non-conductors are used as matrix.

5. Solutions according to one or more of Claims 1 to 4, **characterised in that** the high-molecular-weight component has a molecular weight $M_w$ of greater than 50000 g/mol.

6. Solutions according to one or more of Claims 1 to 5, **characterised in that** substituted poly-p-arylenevinylenes (PAVs), polyfluorenes (PFs), polyspiro-bifluorenes (PSFs), poly-para-phenylenes (PPPs) or -biphenylenes, polydihydro-phenanthrenes (PDHPs), cis- and trans-polyindenofluorenes (PIFs), polythio-phenes (PTs), polypyridines (PPys), copolymers which contain structural units from two or more of the above-mentioned classes, generally conjugated polymers, polyvinylcarbazoles (PVKs), polytriarylamines and/or soluble polymers containing phosphorescent units, which are soluble in organic solvents are employed as polymeric organic semiconductors.

7. Solutions according to one or more of Claims 1 to 6, **characterised in that** nonconducting polymers (matrix polymers) which comprise admixed low-molecular-weight, oligomeric, dendritic or polymeric organic and/or organometallic semiconductors are used.

8. Solutions according to one or more of Claims 1 to 7, **characterised in that** the boiling point of all three solvents A, B and C is greater than 120°C.

9. Solutions according to one or more of Claims 1 to 8, **characterised in that** the difference between the boiling points of solvent A and solvent C is greater than 10 K.

10. Solutions according to one or more of Claims 1 to 9, **characterised in that** the difference between the boiling points of solvent C and solvent B is greater than 10 K.

11. Solutions according to one or more of Claims 1 to 10, **characterised in that** the proportion of solvent A is 10 to 80% by vol., the proportion of solvent B is 0.5 to 40% by vol. and the proportion of solvent C is 10 to 90% by vol.

12. Solutions according to Claim 11, **characterised in that** the proportion of solvent A is 25 to 60% by vol., the proportion of solvent B is 2 to 20% by vol. and the proportion of solvent C is 30 to 70% by vol.

13. Solutions according to one or more of Claims 1 to 12, **characterised in that**, in addition to solvents A, B and C, further good and/or poor solvents are used, which are in each case two or more solvents of type A and/or type B and/or type C

14. Solutions according to one or more of Claims 1 to 13, **characterised in that** mono- or polysubstituted aromatic solvents, formic acid derivatives, N-alkylpyrrolidones or high-boiling ethers are used as solvents A and/or B.

15. Solutions according to Claim 14, **characterised in that** one or more solvents from 3-fluorobenzotrifluoride, benzotrifluoride, dioxane, trifluoromethoxybenzene, 4-fluorobenzotrifluoride, 3-fluoropyridine, toluene, 2-fluorotoluene, 2-fluorobenzotrifluoride, 3-fluorotoluene, pyridine, 4-fluorotoluene, 2,5-difluorotoluene, 1-chloro-2,4-difluorobenzene, 2-fluoropyridine, 3-chlorofluorobenzene, 1-chloro-2,5-difluorobenzene, 4-chlorofluorobenzene, chlorobenzene, 2-chlorofluorobenzene, p-xylene, m-xylene, o-xylene, 2,6-lutidine, 2-fluoro-m-xylene, 3-fluoro-o-xylene, 2-chlorobenzotrifluoride, dimethylformamide, 2-chloro-6-fluorotoluene, 2-fluoroanisole, anisole, 2,3-dimethylpyrazine, bromobenzene, 4-fluoroanisole, 3-fluoroanisole, 3-trifluoromethylanisole, 2-methylanisole, phenetole, benzodioxole, 4-methylanisole, 3-methylanisole, 4-fluoro-3-methylanisole, 1,2-dichlorobenzene, 2-fluorobenzonitrile, 4-fluoroveratrol, 2,6-dimethylanisole, aniline, 3-fluorobenzonitrile, 2,5-dimethylanisole, 2,4-dimethylanisole, benzonitrile, 3,5-dimethylanisole, N,N-dimethylaniline, 1-fluoro-3,5-dimethoxybenzene, phenyl acetate, N-methylaniline, methyl benzoate, N-methylpyrrolidone, 3,4-dimethylanisole, acetophenone, o-tolunitrile, 4-tert-butylanisole, veratrol, ethyl benzoate, N,N-diethylaniline, propyl benzoate, 1-methylnaphthalene, 3,5-dimethoxytoluene, butyl benzoate, 2-methylbiphenyl, dimethylnaphthalene, 2-phenylpyridine or 2,2'-bitolyl are selected as solvents A and/or B.

16. Solutions according to one or more of Claims 1 to 15, **characterised in that** straight-chain, branched or cyclic higher alkanes, preferably having seven or more C atoms, terpenes, (cyclo)aliphatic alcohols, ketones, carboxylic acid esters or mono- or polysubstituted aromatic solvents which are substituted by long alkyl or alkoxy substituents having 4 or more C atoms, higher alcohols having more than 4 C atoms, glycols or ethers thereof are used as solvent C.

17. Solutions according to Claim 16, **characterised in that** at least one solvent C is selected from methylcyclohexane, 3-pentanol, 1,4-dimethylcyclohexane, ethylene glycol monomethyl ether, 1,2-dimethylcyclohexane, octane, 2-hexanol, 1-pentanol, 1,2,4-trimethylcyclohexane, 4-heptanone, 3-heptanone, 2-heptanone, nonane, cyclohexanone, 3-heptanol, 1-hexanol, 2-heptanol, diglyme, butyl butyrate, tert-butylbenzene, decane, 1-heptanol, 2-octanol, butylcyclohexane, 2-ethyl-1-hexanol, decalin, propylene glycol, dimethyl sulfoxide, 3,3,5-trimethylcyclohexanone, glycol, 3,7-dimethyl-1-octanol, 3,7-dimethyl-3-octanol, dimethyl succinate, tert-butyl-m-xylene, benzyl alcohol, DBE, dodecane, diethyl succinate, triglyme, bicyclohexyl, dimethyl adipate, 1-decanol or 2-pyrrolidone, where DBE is defined as a technical-grade mixture of dimethyl succinate and dimethyl glutarate.

18. Use of solutions according to one or more of Claims 1 to 17 for the production of layers of the organic semiconductors on a substrate.

19. Process for the production of organic semiconductor layers on a substrate, **characterised in that** a solution according to one or more of Claims 1 to 17 is processed by means of a printing process.

20. Process according to Claim 19, **characterised in that** the printing process is an ink-jet printing (IJP) process.

**Revendications**

1. Compositions liquides (solutions) à une seule phase comprenant :

   • au moins un semiconducteur organique qui comprend au moins un composant de poids moléculaire élevé,
   • et au moins un solvant organique A,
   • et au moins un solvant organique B,
   • et au moins un solvant organique C,

   **caractérisées en ce que** :

   • le semiconducteur organique est soluble dans le solvant pur A ou dans le solvant pur B selon une concentration d'au moins 5 g/l à température ambiante,
   • la solubilité du semiconducteur organique dans le solvant pur C à température ambiante est inférieure à 0,3 g/l,
   • le point d'ébullition des trois solvants A, B et C est inférieur à 270°C, et
   • ce qui suit s'applique aux points d'ébullition (b.p.) des solvants A, B et C : b.p.(A) < b.p.(C) < b.p.(B), et/ou aux pressions de vapeur respectives (p) à la température du procédé de dépôt des solvants A, B et C : p (A) > p (C) > p (B).

2. Solutions selon la revendication 1, **caractérisées en ce que** le semiconducteur organique est utilisé en tant que composant pur.

3.  Solutions selon la/les revendication(s) 1 et/ou 2, **caractérisées en ce que** le semiconducteur organique est utilisé en tant que mélange de deux composants ou plus.

4.  Solutions selon la revendication 3, **caractérisées en ce qu'**un ou plusieurs non conducteur(s) organique(s) est/sont utilisé(s) en tant que matrice.

5.  Solutions selon une ou plusieurs des revendications 1 à 4, **caractérisées en ce que** le composant de poids moléculaire élevé présente un poids moléculaire $M_w$ supérieur à 50000 g/mol.

6.  Solutions selon une ou plusieurs des revendications 1 à 5, **caractérisées en ce que** des poly-p-arylènevinylènes (PAV) substitués, des polyfluorènes (PF), des polyspiro-bifluorènes (PSF), des poly-para-phénylènes (PPP) ou des poly-para-biphénylènes, des polydihydrophénanthrènes (PDHP), des cis- polyindénofluorènes et des trans-polyindénofluorènes (PIF), des polythiophènes (PT), des polypyridines (PPy), des copolymères qui contiennent des unités structurelles constituées à partir de deux des classes mentionnées ci-avant ou plus, de façon générale, des polymères conjugués, des polyvinylcarbazoles (PVK), des polytriarylamines et/ou des polymères solubles contenant des unités phosphorescentes, qui sont solubles dans des solvants organiques, sont utilisés en tant que semiconducteurs organiques polymériques.

7.  Solutions selon une ou plusieurs des revendications 1 à 6, **caractérisées en ce que** des polymères non conducteurs (des matrices polymères) qui comprennent des semiconducteurs organiques et/ou organométalliques de poids moléculaire faible, oligomériques, dendritiques ou polymériques ajoutés sont utilisés.

8.  Solutions selon une ou plusieurs des revendications 1 à 7, **caractérisées en ce que** le point d'ébullition des trois solvants A, B et C est supérieur à 120°C.

9.  Solutions selon une ou plusieurs des revendications 1 à 8, **caractérisées en ce que** la différence entre les points d'ébullition du solvant A et du solvant C est supérieure à 10 K.

10. Solutions selon une ou plusieurs des revendications 1 à 9, **caractérisées en ce que** la différence entre les points d'ébullition du solvant C et du solvant B est supérieure à 10 K.

11. Solutions selon une ou plusieurs des revendications 1 à 10, **caractérisées en ce que** la proportion du solvant A est de 10 à 80% en vol., la proportion du solvant B est de 0,5 à 40% en vol. et la proportion du solvant C est de 10 à 90% en vol.

12. Solutions selon la revendication 11, **caractérisées en ce que** la proportion du solvant A est de 25 à 60% en vol., la proportion du solvant B est de 2 à 20% en vol. et la proportion du solvant C est de 30 à 70% en vol.

13. Solutions selon une ou plusieurs des revendications 1 à 12, **caractérisées en ce que**, en plus des solvants A, B et C, d'autres solvants bons et/ou médiocres sont utilisés, lesquels sont dans chaque cas deux solvants ou plus de type A et/ou de type B et/ou de type C

14. Solutions selon une ou plusieurs des revendications 1 à 13, **caractérisées en ce que** des solvants aromatiques monosubstitués ou polysubstitués, des dérivés d'acide formique, des N-alkylpyrrolidones ou des éthers à point d'ébullition élevé sont utilisés en tant que solvants A et/ou B.

15. Solutions selon la revendication 14, **caractérisées en ce qu'**un ou plusieurs solvant(s) pris parmi 3-fluorobenzotrifluorure, benzotrifluorure, dioxane, trifluorométhoxybenzène, 4-fluorobenzotrifluorure, 3-fluoropyridine, toluène, 2-fluorotoluène, 2-fluorobenzotrifluorure, 3-fluorotoluène, pyridine, 4-fluorotoluène, 2,5-difluorotoluène, 1-chloro-2,4-difluorobenzène, 2-fluoropyridine, 3-chlorofluorobenzène, 1-chloro-2,5-difluorobenzène, 4-chlorofluorobenzène, chlorobenzène, 2-chlorofluorobenzène, p-xylène, m-xylène, o-xylène, 2,6-lutidine, 2-fluoro-m-xylène, 3-fluoro-o-xylène, 2-chlorobenzotrifluorure, diméthylformamide, 2-chloro-6-fluorotoluène, 2-fluoroanisole, anisole, 2,3-diméthylpyrazine, bromobenzène, 4-fluoroanisole, 3-fluoroanisole, 3-trifluorométhylanisole, 2-méthylanisole, phénétole, benzodioxole, 4-méthylanisole, 3-méthylanisole, 4-fluoro-3-méthylanisole, 1,2-dichlorobenzène, 2-fluorobenzonitrile, 4-fluorovératrol, 2,6-diméthylanisole, aniline, 3-fluorobenzonitrile, 2,5-diméthylanisole, 2,4-diméthylanisole, benzonitrile, 3,5-diméthylanisole, N,N-diméthylaniline, 1-fluoro-3,5-diméthoxybenzène, phénylacétate, N-méthylaniline, méthylbenzoate, N-méthylpyrrolidone, 3,4-diméthylanisole, acétophénone, o-tolunitrile, 4-tert-butylanisole, vératrol, éthylbenzoate, N,N-diéthylaniline, propylbenzoate, 1-méthylnapht-alène, 3,5-diméthoxytoluène, butylbenzoate, 2-méthylbiphényle, diméthylnaphtalène, 2-phénylpyridine ou 2,2'-bitolyle est/sont sélectionné(s) en tant que solvant(s) A et/ou B.

16. Solutions selon une ou plusieurs des revendications 1 à 15, **caractérisées en ce que** des alcanes supérieurs en chaîne droite, ramifiés ou cycliques, de préférence comportant sept atomes de C ou plus, des terpènes, des alcools (cyclo)aliphatiques, des cétones, des esters d'acide carboxylique ou des solvants aromatiques monosubstitués ou polysubstitués qui sont substitués par des substituants alkyle ou alcoxy longs comportant 4 atomes de C ou plus, des alcools supérieurs comportant plus de 4 atomes de C, leurs glycols ou éthers sont utilisés en tant que solvant C.

17. Solutions selon la revendication 16, **caractérisées en ce qu'**au moins un solvant C est sélectionné parmi méthylcyclohexane, 3-pentanol, 1,4-diméthylcyclohexane, éthy-lèneglycolmonométhyléther, 1,2-diméthylcyclohexane, octane, 2-hexanol, 1-pentanol, 1,2,4-triméthylcyclohexane, 4-heptanone, 3-heptanone, 2-heptanone, nonane, cyclohexanone, 3-heptanol, 1-hexanol, 2-heptanol, diglyme, butylbutyrate, tert-butylbenzène, décane, 1-heptanol, 2-octanol, butylcyclohexane, 2-éthyl-1-hexanol, décaline, propy-lèneglycol, diméthylsulfoxyde, 3,3,5-triméthylcyclohexanone, glycol, 3,7-diméthyl-1-octanol, 3,7-diméthyl-3-octanol, diméthylsuccinate, tert-butyl-m-xylène, alcool benzylique, DBE, dodécane, diéthylsuccinate, triglyme, bicyclohexyle, diméthyladipate, 1-décanol ou 2-pyrrolidone, où DBE est défini en tant que mélange de classe technique de diméthylsuccinate et de diméthylglutarate.

18. Utilisation de solutions selon une ou plusieurs des revendications 1 à 17 pour la production de couches des semiconducteurs organiques sur un substrat.

19. Procédé pour la production de couches semiconductrices organiques sur un substrat, **caractérisé en ce qu'**une solution selon une ou plusieurs des revendications 1 à 17 est traitée au moyen d'un procédé d'impression.

20. Procédé selon la revendication 19, **caractérisé en ce que** le procédé d'impression est un procédé d'impression à jet d'encre (IJP).

**Figur 1: Gedruckte Pixel**

Figur 2: Höhenprofil in einem Pixel (durch PL-Intensität gemessen). X-Achse in µm.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- WO 9013148 A
- EP 0880303 A
- WO 0059267 A
- EP 1103590 A
- WO 0116251 A
- WO 02069119 A
- US 20030127977 A
- WO 02072714 A
- EP 0443861 A
- WO 9420589 A
- WO 9827136 A
- EP 1025183 A
- WO 9924526 A
- DE 19953806
- EP 0964045 A
- EP 0842208 A
- WO 0022027 A
- WO 0022026 A
- DE 19981010
- WO 0046321 A
- WO 9954385 A
- WO 0055927 A
- EP 0707020 A
- WO 9617036 A
- WO 9720877 A
- WO 9731048 A
- WO 9739045 A
- WO 03020790 A
- WO 9218552 A
- WO 9507955 A
- EP 0690086 A
- EP 0699699 A
- WO 03099901 A
- DE 10337346
- WO 04041901 A
- EP 03014042 A
- EP 1028136 A
- WO 9505937 A
- WO 02077060 A
- JP 2000072722 A
- EP 1245659 A
- WO 03001616 A
- WO 03018653 A
- WO 03022908 A
- WO 03080687 A
- EP 1311138 A
- WO 03102109 A
- WO 04003105 A
- WO 04015025 A
- WO 03019693 A
- WO 03019694 A
- DE 10337077
- WO 03038923 A

### In der Beschreibung aufgeführte Nicht-Patentliteratur

- **T. YAMAMOTO et al.** *J. Am. Chem. Soc.,* 1994, vol. 116, 4832
- **V. GELLING et al.** *Polym. Prepr.,* 2000, vol. 41, 1770
- Proc. of ICSM '98. *Synth. Met.,* 1999, 101, , 102